# EUROPEAN PATENT APPLICATION

(11) **EP 4 338 608 A1**
(43) Date of publication of application: **20.03.2024**
(21) Application number: 21942004.9
(22) Date of filing: 30.11.2021
(51) Int. Cl.: A24F 40/40, A24F 40/65

(54) **POWER SUPPLY UNIT FOR AEROSOL GENERATOR**

(30) Priority: 10.05.2021 JP 2021079749
(71) Applicant: Japan Tobacco, Inc., Tokyo, 105-6927 (JP)
(72) Inventor: AOYAMA, Tatsunari, Tokyo 130-8603 (JP); KAWANAGO, Hiroshi, Tokyo 130-8603 (JP); NAGAHAMA, Toru, Tokyo 130-8603 (JP); FUJIKI, Takashi, Tokyo 130-8603 (JP); YOSHIDA, Ryo, Tokyo 130-8603 (JP)
(74) Representative: Hoffmann Eitle
(86) International application number: PCT/JP2021/043908
(87) International publication number: WO 2022/239276

(57) **Abstract**

A power source unit 1 for an aerosol generation device comprises: a communication module 62 including an integrated circuit portion 62a and an antenna portion 62b; a power source 10 configured to supply power for driving a heater 25 configured to heat an aerosol source; a controller 71 configured to control the supply of the power from the power source 10 to the heater 25; and a circuit board 6 on which the communication module 62 and an electronic component 61, 63, 64, 161, 162, 163 and 164 are mounted. Of a plurality of side edge portions of the circuit board 6, a first side edge portion 201 closest to the communication module 62 is located at a position closer to the antenna portion 62b than the integrated circuit portion 62a.

## Description

### TECHNICAL FIELD

The present invention relates to a power source unit for an aerosol generation device.

### BACKGROUND ART

Concerning an aerosol generation device, PTL 1 describes mounting an LED and a processor on a circuit board of a controller and providing a Bluetooth^{®} function to the processor. PTLs 2 and 3 each disclose an aerosol generation device having an LED and the Bluetooth^{®} function.

### CITATION LIST

### PATENT LITERATURE

PTL 1: Japanese Patent Laid-Open No. 2020-74585
PTL 2: Japanese Patent Laid-Open No. 2020-114249
PTL 3: Japanese Patent Laid-Open No. 2020-527053

### SUMMARY OF INVENTION

### TECHNICAL PROBLEM

As described above, an aerosol generation device including a communication module such as Bluetooth^{®} is known. Conventionally, on which circuit board the communication module should be mounted or where the communication module should be mounted on the circuit board has not sufficiently been examined, and there is room for improvement.

It is an aspect of the present invention to realize a power source unit for an aerosol generation device capable of mounting a communication module at an appropriate position of a circuit board.

### SOLUTION TO PROBLEM

In a first aspect of the present application, a power source unit for an aerosol generation device is characterized by comprising: a communication module including an integrated circuit portion and an antenna portion; a power source configured to supply power for driving a heater configured to heat an aerosol source; a controller configured to control the supply of the power from the power source to the heater; and a circuit board on which the communication module and an electronic component are mounted, wherein of a plurality of side edge portions of the circuit board, a first side edge portion closest to the communication module is located at a position closer to the antenna portion than the integrated circuit portion.

In the first aspect, a second aspect of the present application is characterized in that a distance between the first side edge portion and the communication module is shorter than a distance between the first side edge portion and the electronic component.

In the first aspect or the second aspect, a third aspect of the present application is characterized in that the antenna portion overlaps the first side edge portion.

In the third aspect, a fourth aspect of the present application is characterized in that a part of the antenna portion is exposed from the first side edge portion to outside the circuit board.

In any one of the first to fourth aspects, a fifth aspect of the present application is characterized by further comprising an insulating chassis configured to hold the circuit board, wherein in a direction perpendicular to a mounting surface of the circuit board, the chassis, the circuit board, and the antenna portion are arranged in this order.

In the fifth aspect, a sixth aspect of the present application is characterized in that in a direction parallel to the mounting surface of the circuit board, the antenna portion and the chassis are adjacent.

In the sixth aspect, a seventh aspect of the present application is characterized in that the antenna portion includes, in the direction parallel to the mounting surface of the circuit board, a first side surface portion adjacent to the chassis, and a second side surface portion located at a position facing the first side surface portion, and the circuit board includes a notch portion formed in a side edge portion located at a position closer to the second side surface portion than the first side surface portion.

In any one of the first to seventh aspects, a eighth aspect of the present application is characterized in that a region where no circuit board is arranged is provided above the antenna portion in the direction perpendicular to the mounting surface of the circuit board.

In any one of the first to seventh aspects, a ninth aspect of the present application is characterized in that an insulating first panel is arranged close to the antenna portion above the antenna portion in the direction perpendicular to the mounting surface of the circuit board.

In the ninth aspect, a tenth aspect of the present application is characterized in that a second panel that is an exterior member of the power source unit is arranged above the first panel in the direction perpendicular to the mounting surface of the circuit board.

In the tenth aspect, a eleventh aspect of the present application is characterized in that to the first panel, a first magnet is exposed at a position apart from the antenna portion by a predetermined distance, the second panel includes a second magnet magnetically coupled with the first magnet, and the power source unit comprises an insulating chassis configured to hold the circuit board and the first magnet such that the first magnet is apart from the antenna portion by the predetermined distance.

### ADVANTAGEOUS EFFECTS OF INVENTION

According to one aspect of the present invention, it is possible to realize a power source unit for an aerosol generation device capable of mounting a communication module at an appropriate position of a circuit board

Other features and advantages of the present invention will be apparent from the following description taken in conjunction with the accompanying drawings. Note that the same reference numerals denote the same or like components throughout the accompanying drawings.

### BRIEF DESCRIPTION OF DRAWINGS

The accompanying drawings, which are incorporated in and constitute a part of the specification, illustrate embodiments of the invention and, together with the description, serve to explain principles of the invention.
Fig. 1A is a front view of a power source unit for an aerosol generation device according to the present embodiment;
Fig. 1B is a top view of a state in which the opening/closing portion of the power source unit for the aerosol generation device according to the present embodiment is closed;
Fig. 1C is a top view of a state in which the opening/closing portion of the power source unit for the aerosol generation device according to the present embodiment is removed;
Fig. 1D is a bottom view of the power source unit for the aerosol generation device according to the present embodiment;
Fig. 2A is a front view of an inner case in a state in which an outer case is removed from the power source unit for the aerosol generation device according to the present embodiment;
Fig. 2B is a rear view of the outer case removed from the power source unit for the aerosol generation device according to the present embodiment;
Fig. 3 is a front view of a state in which the outer case and the cover portion of the inner case are removed from the power source unit for the aerosol generation device according to the present embodiment;
Fig. 4 is a perspective view of a state in which the outer case and the inner case are removed from the power source unit for the aerosol generation device according to the present embodiment;
Fig. 5 is a perspective view of a state in which a slider is further removed from the state shown in Fig. 4;
Fig. 6 is a perspective view of a state in which a chassis and a battery are further removed from the state shown in Fig. 5;
Fig. 7 is a perspective view showing the layout and the mutual connection relationship of the first circuit board and the remaining circuit boards of the power source unit for the aerosol generation device according to the present embodiment;
Fig. 8A is a perspective view showing the layout and the mutual connection relationship of the second circuit board and the remaining circuit boards of the power source unit for the aerosol generation device according to the present embodiment;
Fig. 8B is a perspective view showing the layout and the mutual connection relationship of the second circuit board and the remaining circuit boards of the power source unit for the aerosol generation device according to the present embodiment;
Fig. 9A is a perspective view showing the layout and the mutual connection relationship of the third circuit board and the rest of the power source unit for the aerosol generation device according to the present embodiment;
Fig. 9B is a perspective view showing the layout and the mutual connection relationship of the third circuit board and the rest of the power source unit for the aerosol generation device according to the present embodiment;
Fig. 9C is a perspective view showing the layout and the mutual connection relationship of the third circuit board and the rest of the power source unit for the aerosol generation device according to the present embodiment;
Fig. 10 is a view showing electronic components mounted on the BLE board of the power source unit for the aerosol generation device according to the present embodiment;
Fig. 11A is a view showing electronic components mounted on the MCU board of the power source unit for the aerosol generation device according to the present embodiment;
Fig. 11B is a view showing electronic components mounted on the MCU board of the power source unit for the aerosol generation device according to the present embodiment;
Fig. 12A is a view showing electronic components mounted on the USB board of the power source unit for the aerosol generation device according to the present embodiment;
Fig. 12B is a view showing electronic components mounted on the USB board of the power source unit for the aerosol generation device according to the present embodiment;
Fig. 13 is a view showing a metal inhibition area in the BLE module peripheral portion of the power source unit for the aerosol generation device according to the present embodiment;
Fig. 14 is a sectional view, taken along a line 11 - 11 in Fig. 1A, showing the internal configuration of the power source unit for the aerosol generation device according to the present embodiment; and
Fig. 15 is an overall circuit diagram of the power source unit for the aerosol generation device according to the present embodiment.

### DESCRIPTION OF EMBODIMENTS

Hereinafter, embodiments will be described in detail with reference to the attached drawings. Note, the following embodiments are not intended to limit the scope of the claimed invention, and limitation is not made to an invention that requires a combination of all features described in the embodiments. Two or more of the multiple features described in the embodiments may be combined as appropriate. Furthermore, the same reference numerals are given to the same or similar configurations, and redundant description thereof is omitted.

An example will be described below, in which a power source unit 1 for an aerosol generation device according to the present invention is applied to a heated tobacco product that heats an aerosol source by a heater to generate a gas containing aerosol and a flavor material, or aerosol, or aerosol containing a flavor material. Note that the aerosol source is, for example, a liquid such as a polyhydric alcohol such as glycerin or propylene glycol. The aerosol source may be a solution mixture of a polyhydric alcohol and water. Alternatively, the aerosol source may contain a drug, a Chinese herb, or a flavor component. The aerosol source may be a liquid, a solid, or a mixture of a liquid and a solid. A vapor source such as water may be used in place of the aerosol source.

Also, the aerosol generation device according to the present invention may further include a capsule containing a flavor source. In this case, the aerosol generation device includes a capsule holder that holds the capsule in a detachable state. The flavor source is, for example, a formed body obtained by forming a tobacco material. Alternatively, the flavor source may be formed by a plant (for example, mint, herb, Chinese herb, coffee beans, or the like) other than tobacco. A fragrance such as menthol may be added to the flavor source. The flavor source may be added to the aerosol source.

### [OVERALL CONFIGURATION]

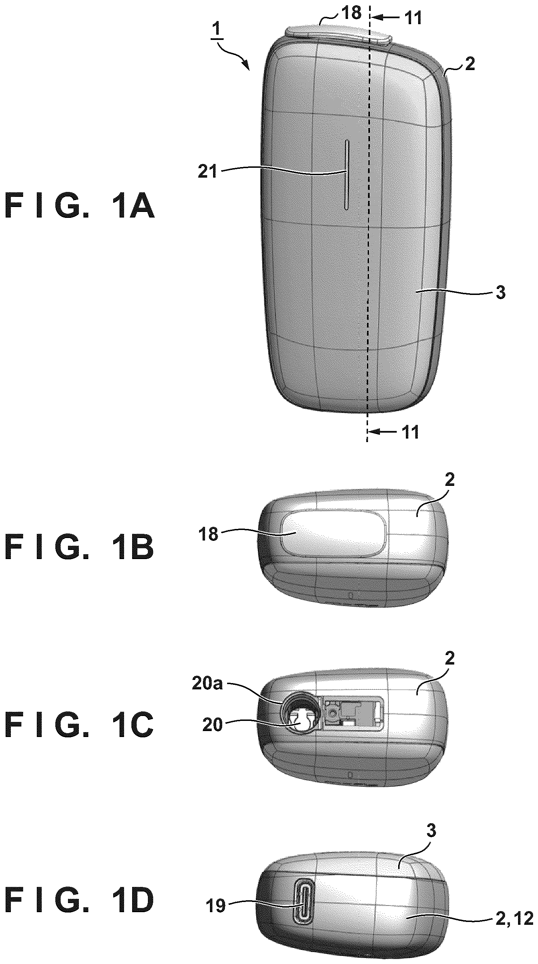

The overall configuration of the power source unit 1 for the aerosol generation device according to the present embodiment will be described first with reference to Figs. 1A to 6.

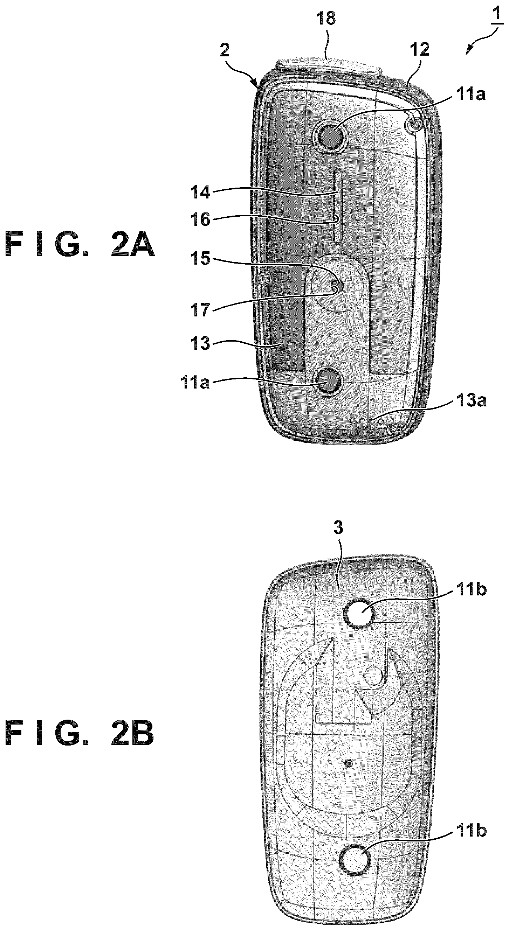

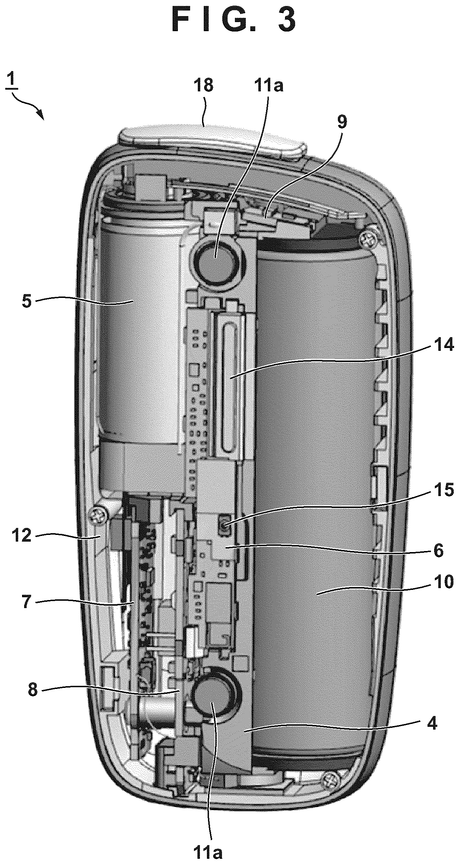

Fig. 1A is a front view of the power source unit for the aerosol generation device according to the present embodiment. Fig. 1B is a top view of a state in which the opening/closing portion of the power source unit for the aerosol generation device according to the present embodiment is closed. Fig. 1C is a top view of a state in which the opening/closing portion of the power source unit for the aerosol generation device according to the present embodiment is removed. Fig. 1D is a bottom view of the power source unit for the aerosol generation device according to the present embodiment. Fig. 2A is a front view of an inner case in a state in which an outer case is removed from the power source unit for the aerosol generation device according to the present embodiment. Fig. 2B is a rear view of the outer case removed from the power source unit for the aerosol generation device according to the present embodiment. Fig. 3 is a front view of a state in which the outer case and the cover portion of the inner case are removed from the power source unit 1 for the aerosol generation device according to the present embodiment.

The power source unit 1 for the aerosol generation device according to the present embodiment includes an inner case 2 that is a first panel forming the entire outer shape, and an outer case 3 that is a second panel. The inner case 2 stores a chassis 4, a heating unit 5, first to fourth circuit boards 6 to 9, and a battery 10. The outer case 3 is attached to the front surface of the inner case 2. The outer case 3 is an exterior member detachable from the inner case 2. On the front surface of the inner case 2, a pair of magnets 11a are provided apart to the upper and lower portions. On the back surface of the outer case 3, a pair of magnets 11b are provided at positions corresponding to the pair of magnets 11a on the inner case 2. The magnets 11a on the inner case 2 attract the magnets 11b on the outer case 3, thereby holding the outer case 3 on the front surface of the inner case 2.

The inner case 2 includes a case main body portion 12 with an open front surface, and a cover portion 13 attached to the front surface of the case main body portion 12. The cover portion 13 is fixed to the opening portion of the front surface of the case main body portion 12 by screws or the like.

The case main body portion 12 of the inner case 2 is provided with a notification unit 14 and an operation unit 15. The notification unit 14 is a light emitting unit formed by an LED and a light guide plate. The operation unit 15 is a push button type operation member such as a tactile switch. In the notification unit 14, lighting of the LED is controlled in accordance with the operation state of the device.

In the cover portion 13 of the inner case 2, a plurality of vent holes 13a for heat dissipation are formed in the lower portion, a long hole 16 configured to expose the LED is formed at a position corresponding to the notification unit 14 of the case main body portion 12, and a round hole 17 configured to expose the tactile switch 15 is formed at a position corresponding to the operation unit 15 of the case main body portion 12. The long hole 16 of the LED has a slit shape extending in the vertical direction in the cover portion 13 of the inner case 2, and the round hole 17 of the tactile switch 15 is formed on the lower side of the long hole 16 of the LED.

The outer case 3 can be made of an elastically deformable material. Thus, if the outer case 3 is pressed in a state in which the outer case 3 is held on the front surface of the inner case 2, the tactile switch 15 can be pressed via the elastically deformed outer case 3.

An opening/closing portion 18 is provided on the upper surface portion of the case main body portion 12 of the inner case 2, and a connecting portion 19 is provided on the lower surface portion. The opening/closing portion 18 is a slide type lid (to be referred to as a slider hereinafter) capable of opening/closing a chamber portion 20 configured to load the aerosol source in the heating unit 5. While holding the cases 2 and 3 by one hand, a user can open/close the slider 18 using the thumb or the like of the hand holding the cases 2 and 3. The connecting portion 19 is an interface used to connect an external device, and is, for example, a USB Type-C receptacle connector (to be referred to as a USB connector hereinafter).

In the front surface of the outer case 3, a lens portion 21 that transmits LED light is provided as a position corresponding to the notification unit 14.

In the case main body portion 12 of the inner case 2, the chassis 4 that holds the heating unit 5, the first to fourth circuit boards 6 to 9, and the battery 10 is stored.

The chassis 4 is made of an insulating (for example, resin) material for holding the first to fourth circuit boards 6 to 9, a vibration generation motor 24, and the magnets 11a and 11b.

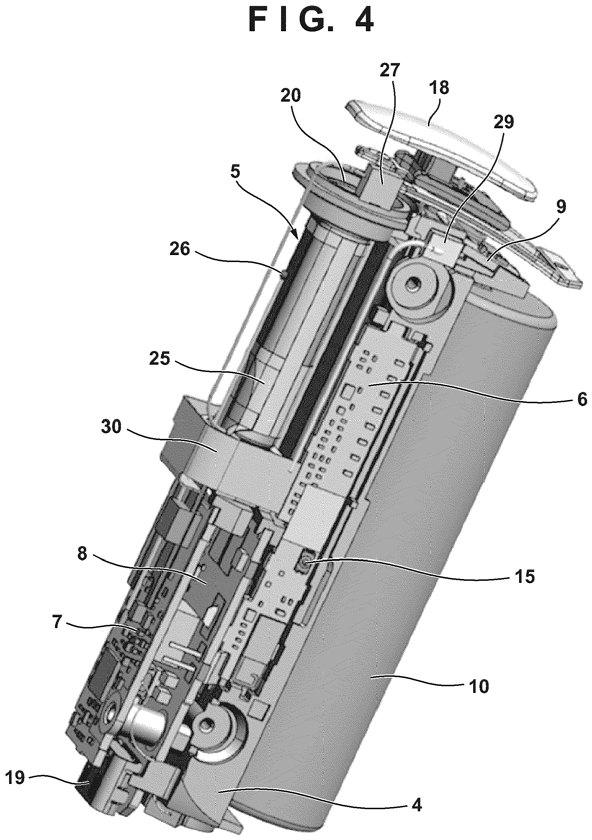

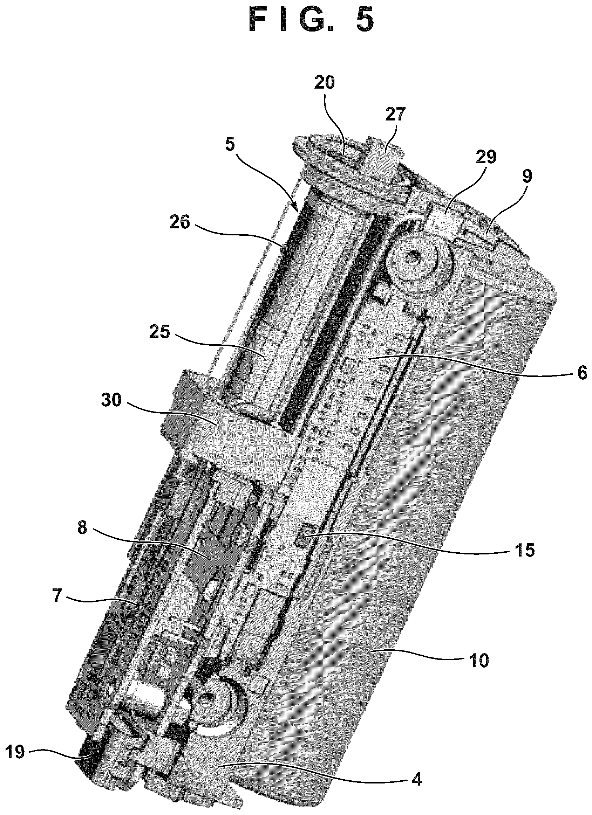

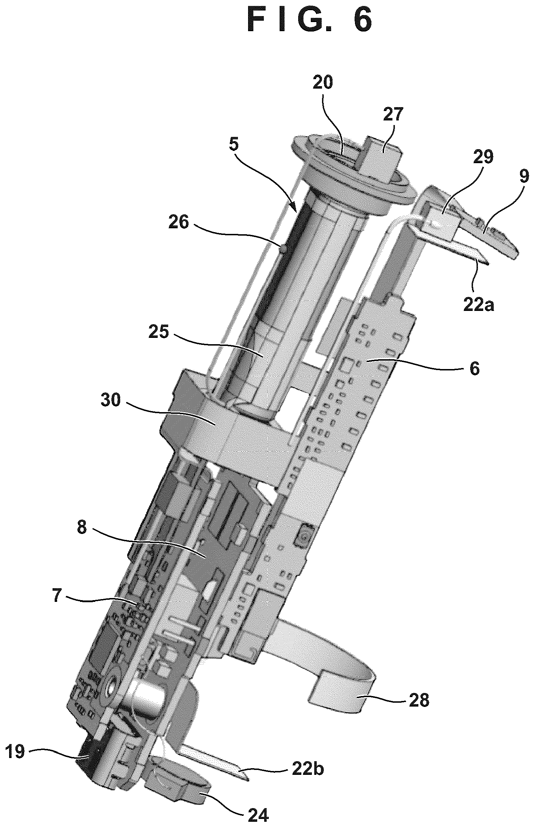

Fig. 4 is a perspective view of a state in which the outer case 3 and the inner case 2 are removed from the power source unit 1 for the aerosol generation device according to the present embodiment. Fig. 5 is a perspective view of a state in which the slider 18 is further removed from the state shown in Fig. 4. Fig. 6 is a perspective view of a state in which the chassis 4 and the battery 10 are further removed from the state shown in Fig. 5. It should be noted that the magnets 11a are also removed from the power source unit 1 for the aerosol generation device in Figs. 4 to 6.

The heating unit 5 includes the cylindrical chamber portion 20 in which the aerosol source is loaded, a heater 25 provided in the chamber portion 20 to heat the aerosol source, a heater temperature detector 26 that detects the temperature of the heater 25, and a puff operation detector 27 that detects a puff operation (an operation is inhaling aerosol). Also, a case temperature detector 29 that detects the temperature inside the inner case 2 is provided near the heating unit 5. The heater 25 may be attached to the power source unit 1 for the aerosol generation device in a form in which the heater can be detached only when destroyed (for example, soldering) or in a form in which the heater can be detached without destruction. Note that in the present embodiment, electrical connection using "connector" will be described as any of a form in which elements can be separated from each other only when destroyed and a form in which elements can be separated from each other without destruction, unless otherwise specified.

The heating unit 5 may be formed by a combination of an induction coil and a susceptor. In this case, the aerosol source is heated by induction heating. The susceptor may be formed as the cylindrical chamber portion 20, or may be provided in the aerosol source.

The battery 10 is a chargeable secondary battery or a capacitor, and is preferably a lithium ion battery. The battery 10 supplies power to each component of the power source unit 1 for the aerosol generation device. The temperature of the battery 10 is detected by a battery temperature detector 28 connected to the third circuit board 8.

Each of the heater temperature detector 26, the puff operation detector 27, the battery temperature detector 28, and the case temperature detector 29 may be formed by a PTC thermistor or an NTC thermistor.

The chamber portion 20 of the heating unit 5 includes an opening portion 20a in which the aerosol source can be attached, and the opening portion 20a can be opened/closed by the slider 18.

The first to fourth circuit boards 6 to 9 are electrically connected by a connecting frame 30 made of a conductive material. The connecting frame 30 is preferably formed by a flexible printed board.

### [Arrangement and Mutual Relationship of Circuit Boards]

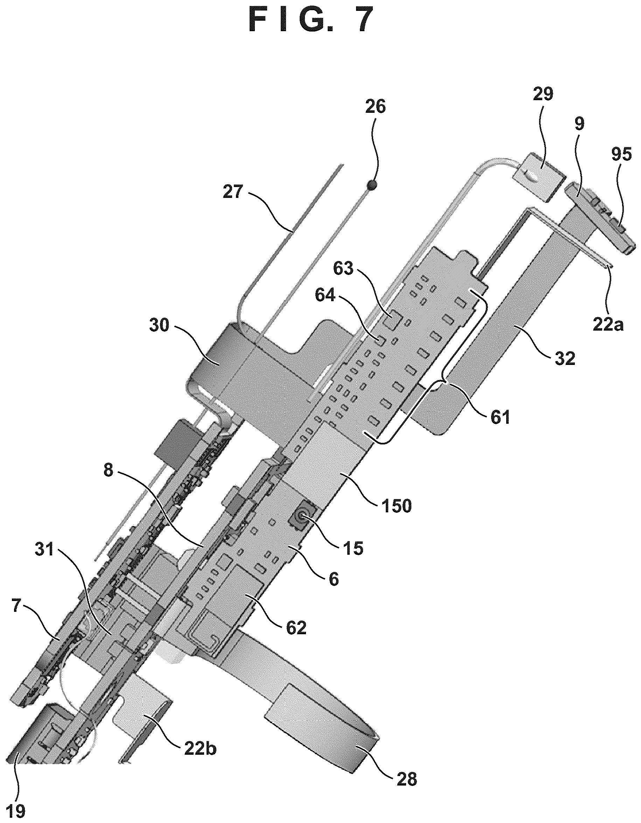

The layout and the mutual relationship of the circuit boards of the power source unit 1 for the aerosol generation device according to the present embodiment will be described next with reference to Figs. 7 to 9C.

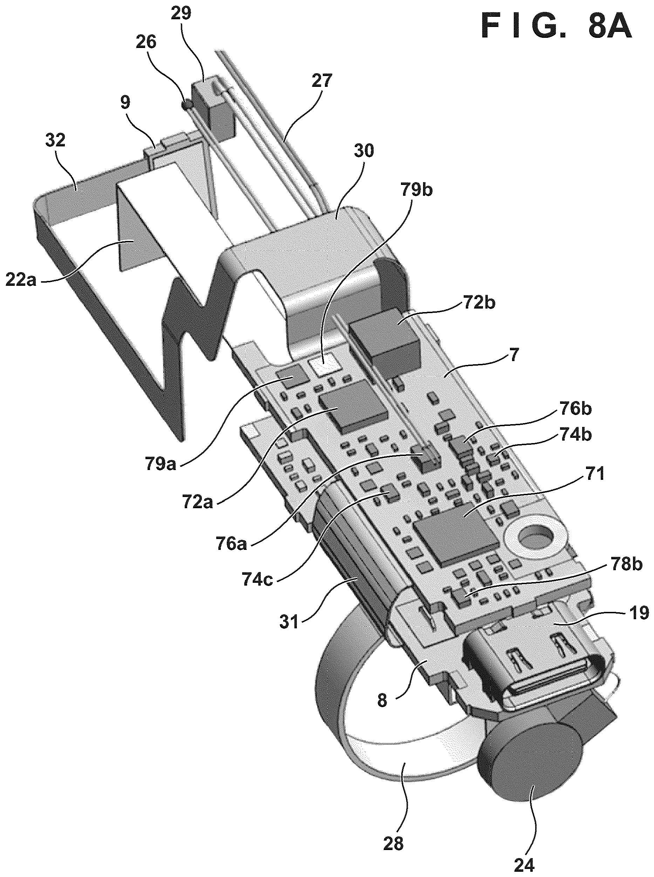

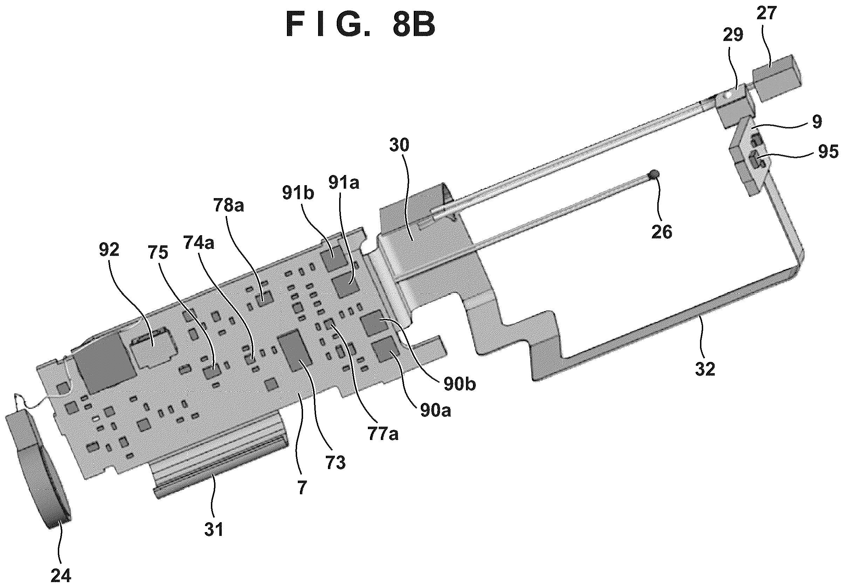

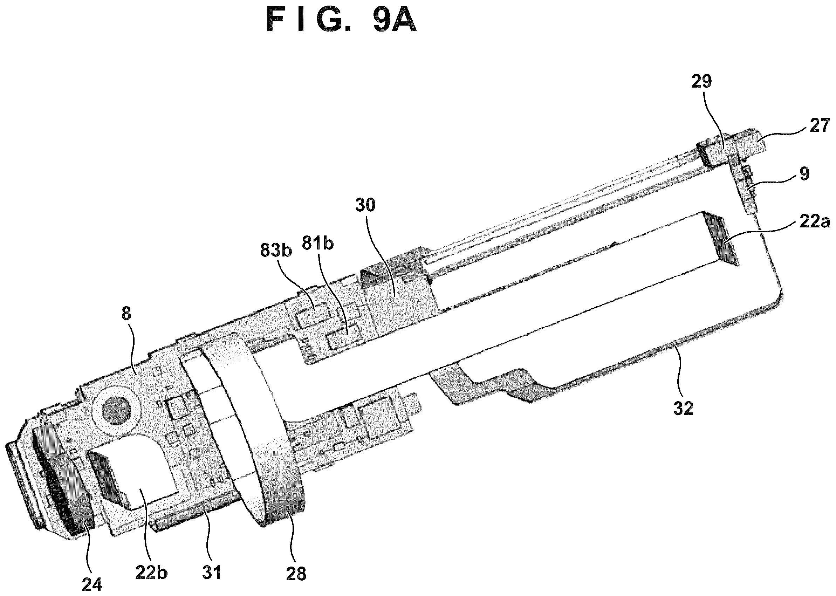

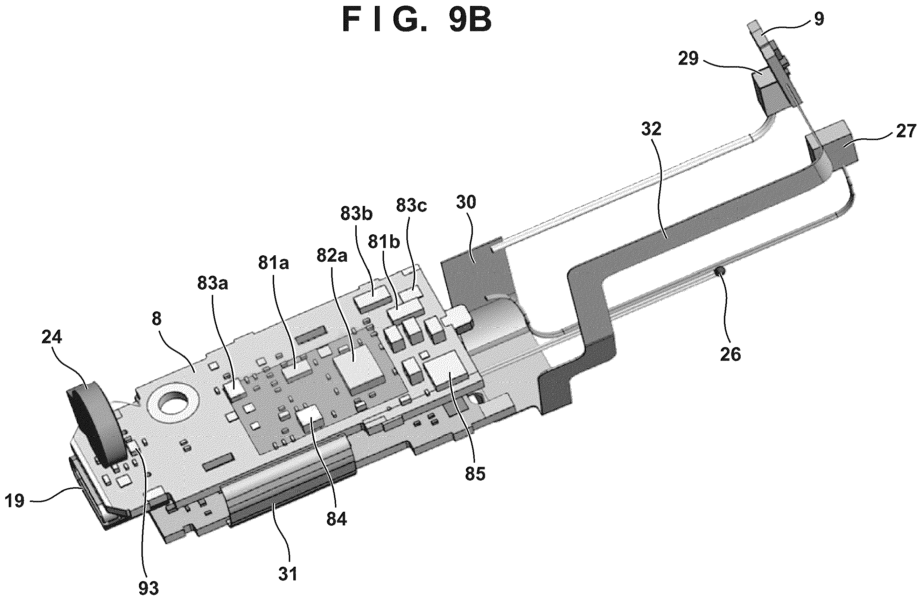

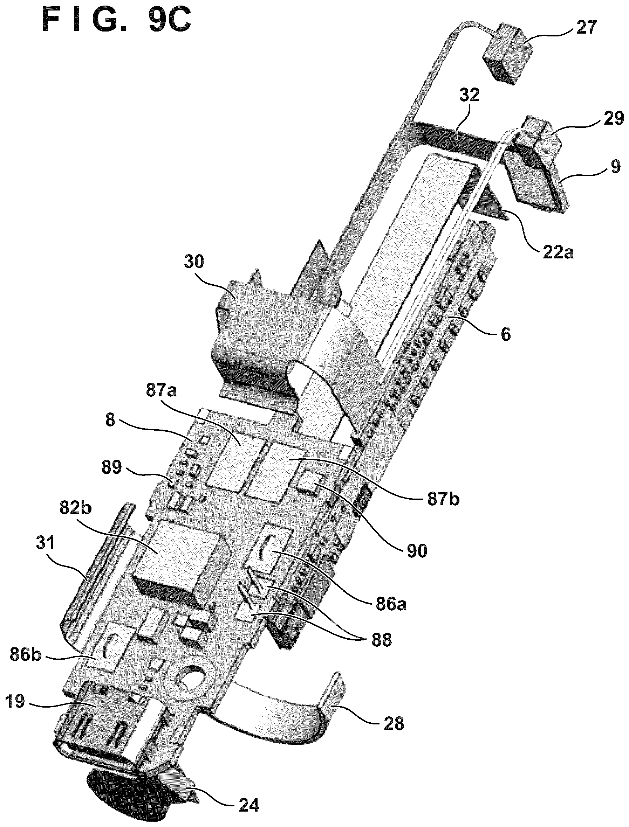

Fig. 7 is a perspective view showing the layout and the mutual connection relationship of the mounting surfaced of the first circuit board 6 and the remaining circuit boards of the power source unit 1 for the aerosol generation device according to the present embodiment. Fig. 8A is a perspective view showing the layout and the mutual connection relationship of the second circuit board and the remaining circuit boards of the power source unit for the aerosol generation device according to the present embodiment. Fig. 8B is a perspective view showing the layout and the mutual connection relationship of the second circuit board and the remaining circuit boards of the power source unit for the aerosol generation device according to the present embodiment. Fig. 9A is a perspective view showing the layout and the mutual connection relationship of the third circuit board and the rest of the power source unit for the aerosol generation device according to the present embodiment. Fig. 9B is a perspective view showing the layout and the mutual connection relationship of the third circuit board and the rest of the power source unit for the aerosol generation device according to the present embodiment. Fig. 9C is a perspective view showing the layout and the mutual connection relationship of the third circuit board and the rest of the power source unit for the aerosol generation device according to the present embodiment.

Fig. 8A mainly shows the obverse surface of the second circuit board 7, and Fig. 8A mainly shows the reverse surface of the second circuit board 7. Figs. 9A and 9B mainly show the reverse surface of the third circuit board 8, and Fig. 9C mainly shows the obverse surface of the second circuit board 8. For the sake of description, Fig. 9B shows a state in which the temperature detector (battery thermistor) 28 of the battery 10, and a negative electrode side bus bar 22a and a positive electrode side bus bar 22b (both will be described later) are removed from the state shown in Fig. 9A.

The first circuit board 6 shown in Fig. 7 is a board (to be referred to as a BLE board hereinafter) on which an LED (Light Emitting Diode) 61, and a communication module (to be referred to as a BLE module hereinafter) 62 such as BLE (Bluetooth^{®} Low Energy) are mounted. In addition to the LED 61 and the BLE module 62, IC chips such as a case attachment/detachment detection circuit (Hall IC) 63 that detects attachment/detachment of the outer case 3 to/from the inner case 2, and a Schmitt trigger circuit (inverter) 64, the tactile switch 15, and other circuits and elements are mounted on the BLE board 6. The Schmitt trigger circuit 64 is provided to impart a hysteresis characteristic to the output of the case attachment/detachment detection circuit 63.

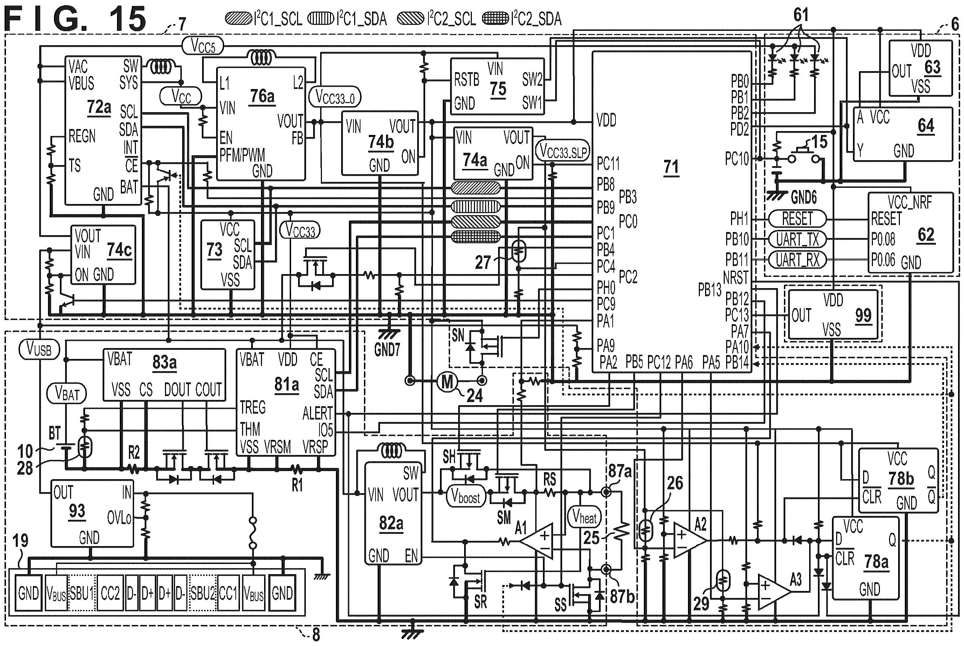

The second circuit board 7 shown in Figs. 8A and 8B is a board (to be referred to as an MCU board hereinafter) on which an MCU (controller) 71 and a charge circuit (charge IC) 72a are mounted. In addition to the MCU 71 and the charge circuit 72a, IC chips such as a reactor (power inductor) 72b of the charge circuit 72a, a nonvolatile memory (ROM) 73, load switch circuits 74a to 74c, a power switch driver circuit 75, a first transformation circuit (DC/DC converter IC) 76a and a reactor (power inductor) 76b, a voltage detection circuit (an operational amplifier A2 shown in Fig. 15) 77a of the heater temperature detector (heater thermistor) 26, a voltage detection circuit (an operational amplifier A3 shown in Fig. 15) 77b of the case temperature detector (case thermistor) 29, a first latch circuit 78a, and a second latch circuit 78b, positive-side/negative-side connectors 79a and 79b of the heater temperature detector (heater thermistor) 26, positive-side/negative-side connectors 90a and 90b of the puff operation detector (puff thermistor) 27, positive-side/negative-side connectors 91a and 91b of the case temperature detector (case thermistor) 29, a connector 92 of the vibration motor 24, and other circuits, ICs, and elements are mounted on the MCU board 7.

It should be noted that in Figs. 8A and 8B, the positive-side/negative-side connectors 79a and 79b of the heater temperature detector (heater thermistor) 26 are not connected to the heater temperature detector (heater thermistor) 26 via lead wires, and this is merely for the sake of convenience of plotting. Actually, the lead wires can be connected to the positive-side/negative-side connectors 79a and 79b of the heater temperature detector (heater thermistor) 26 from a gap in the connecting frame 30. This also applies to the positive-side/negative-side connectors 90a and 90b of the puff operation detector (puff thermistor) 27 and the positive-side/negative-side connectors 91a and 91b of the case temperature detector (case thermistor) 29.

The third circuit board 8 shown in Figs. 9A to 9C is a board (to be referred to as a USB board hereinafter) on which the USB connector 19 is mounted. In addition to the USB connector 19, the negative electrode side bus bar 22a connected to the negative electrode of the battery 10, the positive electrode side bus bar 22b connected to the positive electrode of the battery 10, and the battery temperature detector (battery thermistor) 28 of the battery 10 are connected to the USB board 8. A residual battery amount detection circuit (gas gauge IC) 81a, a current detection resistor 81b of the residual battery amount detection circuit 81a, a second transformation circuit (DC/DC converter IC) 82a and a reactor (power inductor) 82b, a protection circuit (protection IC) 83a, a current detection resistor 83b of the protection circuit 83a, a charge/discharge cutoff switch (MOSFET) 83c controlled by the protection circuit 83a, a heater voltage detection circuit (an operational amplifier A1 shown in Fig. 15) 84, a heater heating switch circuit (MOSFET) 85, a connector 86a of the negative electrode side bus bar 22a, a connector 86b of the positive electrode side bus bar 22b, positive-side/negative-side connectors 87a and 87b of the heater 25, positive-side/negative-side connectors 88 of the battery temperature detector 28, a negative-side switch circuit (MOSFET) 90 of the heater 25, an overvoltage protection circuit (overvoltage protection IC) 93, and other circuits, ICs, and elements are mounted on the USB board 8.

The fourth circuit board 9 shown in Figs. 7, 8A, and 8B is an opening/closing detection board on which an opening/closing detection circuit (Hall IC) 95 that detects opening/closing of the slider 18 is mounted.

The BLE board 6, the MCU board 7, and the USB board 8 each have an elongated shape having a longitudinal direction and a widthwise direction.

The MCU board 7 and the USB board 8 are arranged at positions immediately under the heating unit 5, and are arranged in parallel such that the reverse surface (second surface) of the MCU board 7 and the obverse surface (first surface) of the USB board 8 face each other. The BLE board 6 is arranged while being offset with respect to the MCU board 7 and the USB board 8 such that one end portion in the longitudinal direction at which the BLE module 62 is mounted is located near the center of the MCU board 7 and the USB board 8 in the longitudinal direction, and a region from the vicinity of the center to the other end portion at which the BLE module is not mounted is located between the heating unit 5 and the battery 10. Also, the BLE board 6 is arranged such that the mounting surface (first surface) of the BLE board 6 is substantially orthogonal to the mounting surfaces (the obverse surface and the reverse surface) of the MCU board 7 and the USB board 8.

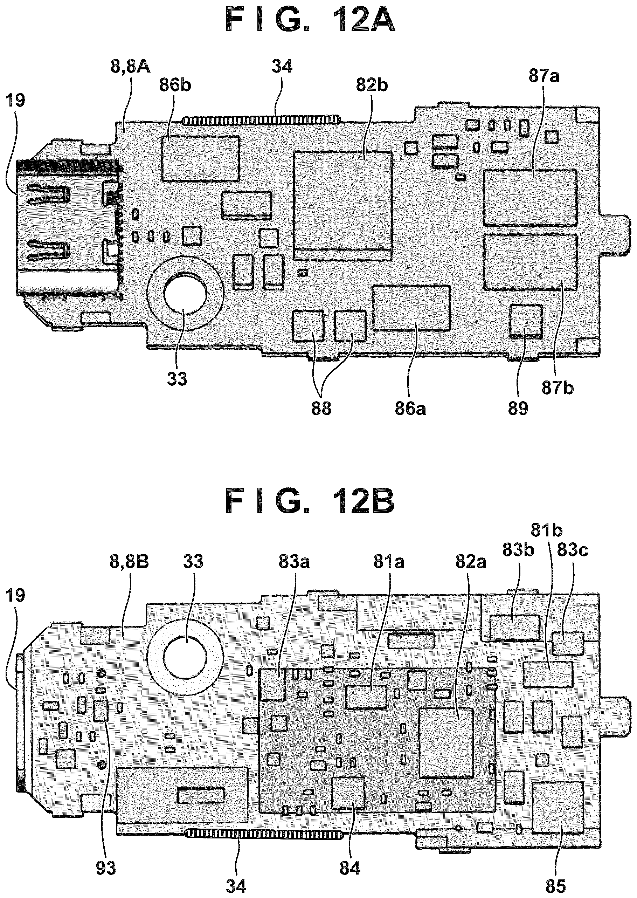

The MCU board 7 and the USB board 8 are electrically connected by a connector provided on the MCU board 7, a connector 34 (see Figs. 12A and 12B) provided on the USB board 8, and a flexible board 31 connected to the MCU board 7. The BLE board 6 is electrically connected to the MCU board 7 by the connecting frame 30. The opening/closing detection board 9 is electrically connected to the MCU board 7 by a branch frame 32 branching from the connecting frame 30. The branch frame 32 is preferably formed by a flexible printed board.

### [Circuit Configuration]

The circuit configuration of the power source unit 1 for the aerosol generation device according to the present embodiment will be described next with reference to Fig. 15.

Fig. 15 is a circuit diagram of the power source unit 1 for the aerosol generation device according to the present embodiment.

A power source BT is the battery 10. The protection circuit 83a is a protection IC that measures, using a resistor R2 arranged in a path to which a current output from the power source BT flows, the current flowing to the path and protects the power source BT in accordance with the current. The residual battery amount detection circuit 81a is a gas gauge IC (residual meter IC) that measures the state of the power source BT using a resistor R1 arranged in the path to which the current output from the power source BT flows. The overvoltage protection circuit 93 is an overvoltage protection IC that receives a voltage V_{BUS} supplied from the USB connector 19 serving as a power feeder connector and outputs a voltage V_{USB} to a V_{USB} line. The overvoltage protection circuit 93 has a function of, even if the voltage V_{BUS} supplied from the USB connector 19 is a voltage higher than a predetermined voltage value, lowering the voltage to the predetermined voltage value and supplying it to the output side of the overvoltage protection circuit 93.

The second transformation circuit 82a is a DC/DC converter including a switching regulator that transforms a power source voltage V_{BAT} supplied from the power source BT to generate a heater voltage V_{BOOST} used to drive the heater 25. From the viewpoint of increasing the amount of aerosol generated by the heater 25, the second transformation circuit 82a is DC/DC converter having a step-up function, preferably, a step-up DC/DC converter or a step-up/down DC/DC converter.

When causing the heater 25 to generate heat, the MCU 71 turns off a switch SM and turns on a switch SH and a switch SS, and the heater voltage V_{BOOST} is supplied to the heater 25 via the switch SH. When measuring the temperature or resistance of the heater 25, the MCU 71 turns off the switch SH, and turns on the switch SM and the switch SS, and the heater voltage V_{BOOST} is supplied to the heater 25 via the switch SM. When measuring the temperature or the resistance value of the heater 25, the operational amplifier A1 supplies an output according to the voltage between the positive side terminal and the negative side terminal of the heater 25, in other words, the voltage between the positive-side/negative-side connectors 87a and 87b of the heater 25 to the PA7 terminal of the MCU 71. The operational amplifier A1 functions as a temperature detection circuit that measures the resistance value or the temperature of the heater 25. A shunt resistor RS is arranged in a path that electrically connects the switch SM and the positive-side connector 87a of the heater 25. The resistance value of the shunt resistor RS can be decided such that a switch SR is ON in a period in which the heater 25 is heated, and the switch SR is OFF in a period in which the temperature or the resistance value of the heater 25 is measured.

If the switch SR is formed by an n-channel MOSFET, the drain terminal of the switch SR is connected to the output terminal of the operational amplifier A1, the gate terminal of the switch SR is connected between the shunt resistor RS and the positive-side connector 87a of the heater 25, and the source terminal of the switch SR is connected to ground. A value obtained by dividing the heater voltage V_{BOOST} mainly by the shunt resistor RS and the heater 25 is input to the gate terminal of the switch SR. The resistance value of the shunt resistor RS can be decided such that the value obtained by the voltage division is equal to or larger than the threshold voltage of the switch SR. In addition, by the shunt resistor RS, a current flowing to the heater 25 when the switch SH is turned off, and the switch SM and the switch SS are turned on is smaller than a current flowing to the heater 25 when the switch SH and the switch SS are turned on, and the switch SM is turned off. This makes it difficult for the temperature of the heater 25 to change due to the current flowing to the heater 25 when measuring the temperature or resistance of the heater 25.

The load switch circuit 74c electrically disconnects the VIN terminal from the VOUT terminal when low level is input to the ON terminal. When high level is input to the ON terminal, the load switch circuit 74c electrically connects the VIN terminal and the VOUT terminal and outputs a voltage Vccs from the VOUT terminal to a Vccs line. The voltage value of the voltage Vccs is, for example, 5.0 [V]. The Vccs line is connected to the VBUS terminal and the VAC terminal of the charge circuit 72a and the LED 61. Note that the collector terminal of an npn-type bipolar transistor is connected to the ON terminal of the load switch circuit 74c. The emitter terminal of the bipolar transistor is connected to ground GND7, and the base terminal is connected to the PC9 terminal of the MCU 71. That is, the MCU 71 adjusts the potential of the PC9 terminal, thereby controlling opening/closing of the load switch 74c via the bipolar transistor.

The charge circuit 72a is a charge IC that, in a charge mode, electrically connects the SYS terminal and the BAT terminal internally and supplies a charge voltage from the BAT terminal to the power source BT. The charge mode is enabled or activated by supplying low level to the ICE terminal. In a power-pass mode, the charge circuit 72a electrically connects the VBUS terminal and the SW terminal, and supplies a voltage Vcc to a Vcc line using a voltage Vccs supplied via a Vccs line and/or the power source voltage V_{BAT} supplied from the power source BT to the BAT terminal. In an OTG mode, the charge circuit 72a receives the power source voltage V_{BAT} supplied from the power source BT to the BAT terminal and supplies the voltage Vcc from the SYS terminal to the Vccs line, and also supplies the voltage Vccs from the VBUS terminal to the Vccs line. The charge circuit 72a in the OTG mode preferably steps up the power source voltage V_{BAT} supplied to the BAT terminal and supplies it from the VBUS terminal to the Vccs line such that the voltage Vccs supplied from the VBUS terminal to the Vccs line also becomes 5.0 [V] in the OTG mode. If high level is supplied to the ICE terminal, the charge circuit 72a operates in an operation mode set by default from the power-pass mode and the OTG mode, or in an operation mode set by the MCU 71.

The first transformation circuit 76a is enabled by supplying the voltage Vcc to the Vcc line. More specifically, the first transformation circuit 76a is enabled by inputting a signal of high level to the EN terminal. Since the VIN terminal and the EN terminal are connected to the Vcc line, the first transformation circuit 76a is enabled by supplying the voltage Vcc to the Vcc line. The first transformation circuit 76a is a DC/DC converter including a switching regulator that supplies a voltage V_{CC33_0} from the VOUT terminal to the V_{CC33_0} line. More preferably, the first transformation circuit 76a is a step-up/down DC/DC converter. The voltage value of the voltage V_{CC33_0} is, for example, 3.3 [V]. The V_{CC33_0} line is connected to the VIN terminal of the load switch circuit 74b, the VIN terminal and the RSTB terminal of the power switch driver circuit 75, and the VCC terminal and the D terminal of the second latch circuit 78b.

The load switch circuit 74b electrically disconnects the VIN terminal from the VOUT terminal when low level is input to the ON terminal, and when high level is input to the ON terminal, electrically connects the VIN terminal and the VOUT terminal and outputs the voltage V_{CC33} from the VOUT terminal to the V_{CC33} line. The voltage value of the voltage V_{CC33} is, for example, 3.3 [V]. The V_{CC33} line is connected to the VIN terminal of the load switch 74a, the VCC terminal of the nonvolatile memory 73, the VDD terminal and the CE terminal of the residual battery amount detection circuit 81a, the VDD terminal of the MCU 71, the VDD terminal of the case attachment/detachment detection circuit 63, the VCC terminal of the Schmitt trigger circuit 64, the VCC NRF terminal of the BLE module 62, the VDD terminal of the opening/closing detection circuit 95, the VCC terminal and the D terminal of the first latch circuit 78a, the positive power source terminal of the operational amplifier A1, the positive power source terminal of the operational amplifier A2, and the positive power source terminal of the operational amplifier A3. The VIN terminal to the load switch 74b is electrically connected to the VOUT terminal of the first transformation circuit 76a, and the voltage V_{CC33_0} is supplied from the first transformation circuit 76a.

If low level is supplied to the SW1 terminal and the SW2 terminal for a predetermined time, the power switch driver circuit 75 outputs low level from the RSTB terminal. The RSTB terminal is electrically connected to the ON terminal of the load switch circuit 74b. Hence, if low level is supplied to the SW1 terminal and the SW2 terminal of the power switch driver circuit 75, the load switch circuit 74b stops the output of the voltage V_{CC33} from the VOUT terminal. If the output of the voltage V_{CC33} from the VOUT terminal of the load switch circuit 74b stops, supply of the voltage V_{CC33} to the VDD terminal (power source terminal) of the MCU 71 is cut off, and therefore, the MCU 71 stops the operation.

It is preferable that the power switch driver circuit 75 does not output low level from the RSTB terminal after low level is output from the RSTB terminal. If low level is not output from the RSTB terminal, the voltage V_{CC33_0} is input to the ON terminal of the load switch circuit 74b. Hence, the load switch 74b outputs the voltage V_{CC33} from the VOUT terminal to the V_{CC33} line again. This can reactivate the MCU 71 that has stopped the operation.

If the outer case 3 is detached from the inner case 2, low level is supplied from the case attachment/detachment detection circuit 63 to the SW2 terminal of the power switch driver circuit 75 via the Schmitt trigger circuit 64. The SW1 terminal of the power switch driver circuit 75 and the PC10 terminal of the MCU 71 are connected to ground GND6 via the tactile switch 15. For this reason, if the tactile switch 15 is pressed, low level is supplied to the SW1 terminal of the power switch driver circuit 75. Hence, if the tactile switch 15 is pressed in a state in which the outer case 3 is detached from the inner case 2, low level is supplied to the SW1 terminal and the SW2 terminal of the power switch driver circuit 75. If low level is supplied to the SW1 terminal and the SW2 terminal for a predetermined time (for example, several sec), the power switch driver circuit 75 recognizes that a reset or reactivation instruction for the power source unit 1 for the aerosol generation device is input.

The load switch circuit 74a electrically disconnects the VIN terminal from the VOUT terminal when low level is input to the ON terminal, and when high level is input to the ON terminal, electrically connects the VIN terminal and the VOUT terminal and outputs a voltage V_{CC33_SLP} from the VOUT terminal to a V_{CC33_SLP} line. The voltage value of the voltage V_{CC33_SLP} is, for example, 3.3 [V]. The V_{CC33_SLP} line is connected to the heater temperature detector (heater thermistor) 26, the puff operation detector (puff thermistor) 27, and the case temperature detector (case thermistor) 29. The ON terminal of the load switch circuit 74a is electrically connected to the PC11 terminal of the MCU 71. When shifting to a sleep mode, the MCU 71 changes the logic level of the PC11 terminal from high level to low level, and when shifting from the sleep mode to an active mode, changes the logic level of the PC11 terminal from low level to high level.

The MCU 71 detects the temperature change of an air channel associated with the puff operation using the resistance value change of the puff thermistor 27. The MCU 71 can acquire the resistance value change of the puff thermistor 27 from the value of the voltage input to the PC4 terminal.

The vibration motor 24 is activated by turning on a switch SN. The switch SN may be formed by a transistor, and a control signal is supplied from the PH0 terminal of the MCU 71 to the base or the gate of the transistor. In place of the switch SN, the driver IC of the vibration motor 24 may be used.

The MCU 71 detects the temperature of the heater 25 using the resistance value change of the heater thermistor 26. The temperature of the heater 25 may indirectly be detected by detecting the temperature near the heater 25. The MCU 71 can acquire the resistance value change of the heater thermistor 26 from the value of the voltage input to the PA6 terminal. The operational amplifier A2 outputs a voltage according to the resistance value of the heater thermistor 26, in other words, a voltage according to the temperature of the heater 25.

The MCU 71 detects the temperature in the inner case 2 using the resistance value change of the case thermistor 29. The MCU 71 can acquire the resistance value change of the case thermistor 29 from the value of the voltage input to the PA3 terminal. The operational amplifier A3 outputs a voltage according to the resistance value of the case thermistor 29, in other words, a voltage according to the temperature of the inner case 2.

The MCU 71 (controller) includes a processor formed as an IC chip, and controls the operation of the entire power source unit 1 for the aerosol generation device by executing a program stored in the nonvolatile memory 73 or an internal memory.

The MCU 71 performs heating control of the heater 25 and charge/discharge control of the battery 10. If the tactile switch 15 is long-pressed in a state in which the outer case 3 is attached, the MCU 71 starts heating control of the heater 25. More specifically, heating control of the heater 25 can be started when high level is supplied from the PC12 terminal of the MCU 71 to the gate terminal of the switch SS and the EN terminal of the second transformation circuit 82a. Thus, the negative-side connector 87b of the heater 25 and the ground are connected, and the second transformation circuit 82a outputs the heater voltage V_{BOOST}. In this state, if the MCU 71 outputs low level from the PA2 terminal to the gate terminal of the switch SH, the switch SH is turned on, and the heater voltage V_{BOOST} is supplied to the heater 25.

The MCU 71 controls supply of power to the heater 25 that is configured to heat the aerosol source using the power of the power source BT, thereby controlling heat generation of the heater 25. More specifically, the MCU 71 controls heat generation of the heater 25 by PWM control or PFM control of the switch SH. The duty ratio in PWM control or PFM control may be calculated by PID control. The MCU 71 may acquire the temperature of the heater 25 necessary for PID control from the output of the operational amplifier A1 or from the input to the PC6 terminal.

If the tactile switch 15 is long-pressed in a state in which the slider 18 is closed, the MCU 71 starts pairing by BLE.

The case attachment/detachment detection circuit 63 is a Hall IC that detects that the outer case 3 is detached from the aerosol generation device or the power source unit 1. The output of the case attachment/detachment detection circuit 63 is supplied to the SW2 terminal of the power switch driver circuit 75 and the PD2 terminal of the MCU 71 via the Schmitt trigger circuit 64. The output of the opening/closing detection circuit 95 is supplied to the PC13 terminal of the MCU 71.

The BLE module 62 is a communication module that provides, to the MCU 71, a function for communicating with an external device such as a smartphone, a portable telephone, or a personal computer, complying with a short-range wireless communication standard such as Bluetooth^{®}. Note that the communication module may be a communication module complying with not BLE but another communication standard such as NFC (Near Field Communication) or a wireless LAN (Local Area Network).

The first latch circuit 78a is a flip-flop circuit that holds an output to stop charge/discharge at the time of overheat of the heater 25. The first latch circuit 78a is preferably a D flip-flop IC. The second latch circuit 78b is a flip-flop circuit that stores the occurrence of overheat at the time of overheat of the heater 25. The second latch circuit 78b is preferably a D flip-flop IC.

In the present embodiment, the cathode of the LED 61 mounted on the BLE board 6 is not connected to the ground GND6 of the BLE board 6 and is connected to the MCU 71 on the MCU board 7. Thus decreases the ground of the BLE board 6. Also, the anode of the LED 61 is connected to the load switch 74c on the MCU board 7, the voltage Vccs is applied, and discharge to the LED 61 is controlled by the MCU 71. Since this can reduce the influence of noise (ground noise) generated by the ground GND6 of the BLE board 6 in association with the discharge to the LED on the BLE board 6, the communication state by the BLE module 62 can be held in a satisfactory state. In addition, the MCU 71 that controls discharge to the LED 61 is mounted on the MCU board 7 separated from the BLE board 6. Since the influence of noise generated by discharge control on the BLE module 62 can be reduced, the communication state by the BLE module 62 can be held in a satisfactory state.

### [Electronic Components Mounted on Circuit Boards]

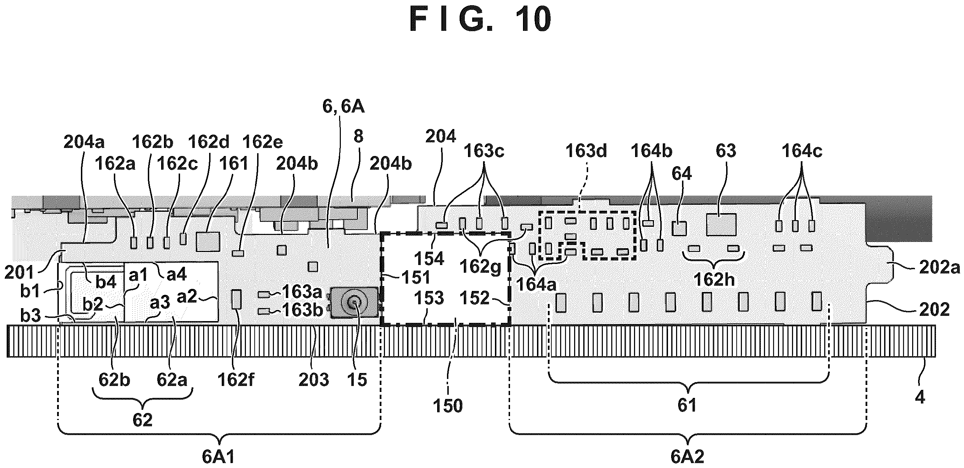

Electronic components mounted on the circuit boards of the power source unit 1 for the aerosol generation device according to the present embodiment will be described next with reference to Figs. 10 to 12B.

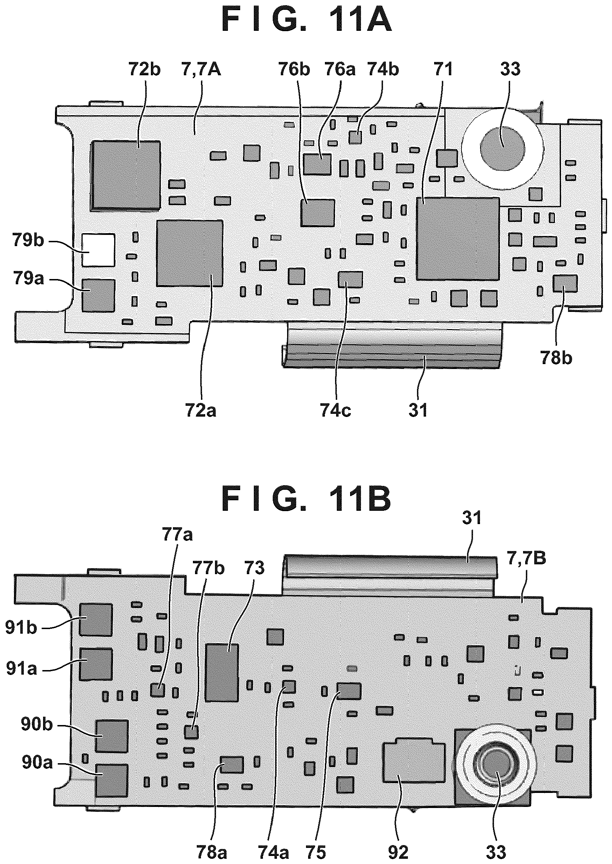

Fig. 10 is a view showing electronic components mounted on the BLE board 6 of the power source unit 1 for the aerosol generation device according to the present embodiment. Fig. 11A is a view showing electronic components mounted on the MCU board of the power source unit for the aerosol generation device according to the present embodiment. Fig. 11B is a view showing electronic components mounted on the MCU board of the power source unit for the aerosol generation device according to the present embodiment. Fig. 12A is a view showing electronic components mounted on the USB board of the power source unit for the aerosol generation device according to the present embodiment. Fig. 12B is a view showing electronic components mounted on the USB board of the power source unit for the aerosol generation device according to the present embodiment.

As shown in Fig. 10, the BLE board 6 includes a first surface 6A on which electronic components are mounted, and a second surface 6B (not shown) on the reverse side of the first surface 6A. On the first surface 6A of the BLE board 6, IC chips such as the LED 61, the BLE module 62, the case attachment/detachment detection circuit 63, and the Schmitt trigger circuit 64, and circuits and elements such as the tactile switch 15, a crystal oscillator 161, capacitors 162a to 162h, overvoltage protection elements (Zener diodes or varistors) 163a to 163d, and resistors 164a to 164c are mounted. The mutual layout relationship between the electronic components and the circuits boards for maintaining the communication state of the BLE module 62 in a satisfactory state will be described later.

As shown in Figs. 11A and 11B, the MCU board 7 includes a first surface 7A (obverse surface) on which electronic components are mounted, and a second surface 7B (reverse surface) on the reverse side of the first surface 7A. On the first surface 7A of the MCU board 7, IC chips such as the MCU 71, the charge circuit 72a, the reactor (power inductor) 72b of the charge circuit 72a, the load switch circuits 74b and 74c, the first transformation circuit 76a and the reactor 76b, and the second latch circuit 78b, and other circuits, ICs, and elements such as the positive-side/negative-side connectors 79a and 79b of the heater thermistor 26 are mounted.

On the second surface 7B of the MCU board 7, IC chips such as the nonvolatile memory (ROM) 73, the load switch circuit 74a, the power switch driver circuit 75, the voltage detection circuit 77a of the heater thermistor 26, the voltage detection circuit 77b of the case thermistor 29, and the first latch circuit 78a, and other circuits, ICs, and elements such as the positive-side/negative-side connectors 90a and 90b of the puff thermistor 27, the positive-side/negative-side connectors 91a and 91b of the case thermistor 29, and the connector 92 of the vibration motor 24 are mounted.

Note that a circular spacer 33 is formed in the MCU board 7. The spacer 33 is a positioning screw hole configured to position the MCU board 7 and the USB board 8.

As shown in Figs. 12A and 12B, the USB board 8 includes a first surface 8A (obverse surface) on which electronic components are mounted, and a second surface 8B (reverse surface) on the reverse side of the first surface 8A. On the first surface 8A of the USB board 8, the USB connector 19, the reactor (power inductor) 82b of the second transformation circuit 82a, the connector 86a of the negative electrode side bus bar 22a, the connector 86b of the positive electrode side bus bar 22b, the positive-side/negative-side connectors 87a and 87b of the heater 25, the positive-side/negative-side connectors 88 of the battery thermistor 28, a negative-side switch circuit 89 of the heater 25, and the like are mounted.

Also, on the second surface 8B of the USB board 8, the residual battery amount detection circuit 81a, the current detection circuit 81b of the residual battery amount detection circuit 81a, the second transformation circuit 82a, the protection circuit 83a, the current detection circuit 83b of the protection circuit 83a, the charge/discharge cutoff switch 83c controlled by the protection circuit 83a, the heater voltage detection circuit 84, the heater heating switch circuit 85, the overvoltage protection circuit 93, and the like are mounted.

Note that the circular spacer 33 is formed in the USB board 8. The spacer 33 is a positioning screw hole configured to position the MCU board 7 and the USB board 8. In addition, a connector 34 configured to connect the flexible board 31 connected to the MCU board 7 is provided on the side edge portion of the USB board 8.

### [Arrangement Relationship between BLE Module, Electronic Components, and Circuit Boards]

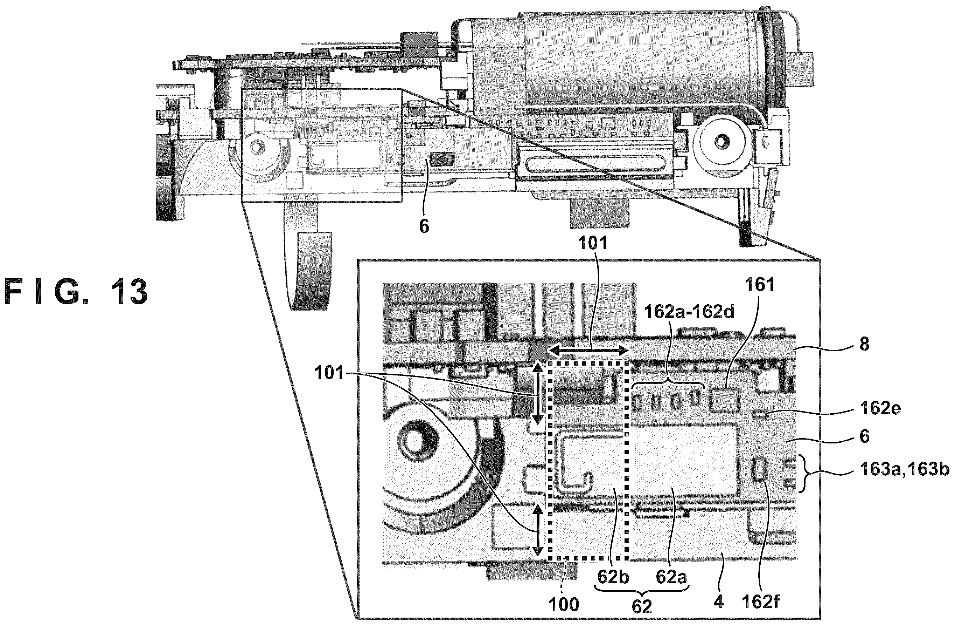

The layout relationship between the BLE module 62, the electronic components, and the circuit boards of the power source unit 1 for the aerosol generation device according to the present embodiment will be described next with reference to Figs. 13 to 15 in addition to Figs. 1A to 12B.

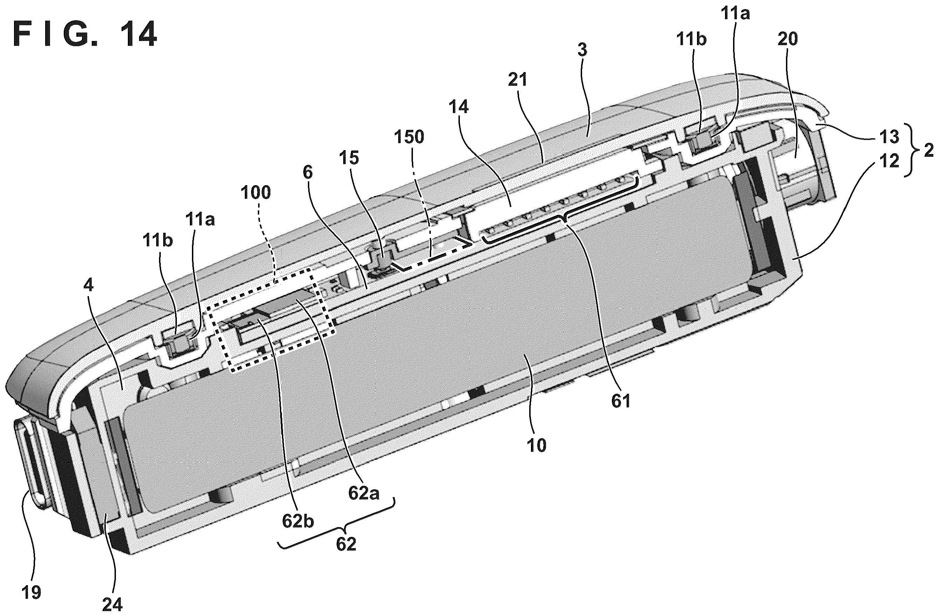

Fig. 13 is an explanatory view of an inhibition area of metal components, metal housings, metal plates, and the like in the BLE module 62, and an inhibition area of copper foil (conductive line) patterns. The overview of the BLE board 6 and electronic components on the periphery are shown on the upper side of Fig. 13, and an enlarged view of the BLE module 62 and its periphery is shown on the lower side of Fig. 13. Fig. 14 is a sectional view taken along a line 11 - 11 in Fig. 1A.

As shown in Fig. 13, the BLE module 62 generally includes an integrated circuit portion 62a and an antenna portion 62b. When mounting the BLE module 62 on the BLE board 6, to reduce the influence of other electronic components on the BLE module 62 (in particularly, the antenna region 62b), it is preferable to ensure an inhibition area (first inhibition area) 100 of metal components, metal housings, metal plates, and the like, and inhibition areas (second inhibition areas) 101 of copper foil (conductive line) patterns. The inhibition area (first inhibition area) 100 of metal components, metal housings, metal plates, and the like is an area on the lower and upper sides of a portion where the antenna region 62b is mounted on the BLE board 6. The inhibition areas (second inhibition areas) 101 of copper foil (conductive line) patterns are areas on the lateral sides of the antenna region 62b and immediately under it in the BLE board 6. In particular, in the second inhibition areas 101, it is preferable not to use copper foil (conductive line) patterns in all layers of the BLE board 6, and this is a great restriction on circuit design.

In the present embodiment, the first inhibition area 100 and the second inhibition areas 101, which are configured to avoid the influence of noise in communication of the BLE module 62, are provided around the position where the BLE module 62 is mounted on the BLE board 6.

In the present embodiment, the BLE module 62 is mounted at the side edge portion of the BLE board 6, thereby reducing the influence of other electronic components (the LED 61, the case attachment/detachment detection circuit 63, and the Schmitt trigger circuit 64, and the MCU 71, the second transformation circuit 82a, the first transformation circuit 76a, and the like are mounted on other circuit boards, each of which may be a noise source). Also, the first inhibition area 100 of the BLE module 62 is created using the inner case 2, the outer case 3, and the chassis 4, and the BLE board 6 is held by the chassis 4, thereby ensuring the second inhibition areas 101 of the BLE module 62.

As shown in Fig. 14, the first inhibition area 100 is a region in the vertical direction of the BLE module 62. The first inhibition area 100 is preferably a region of 10 mm or more in the vertical direction of the BLE module 62. The second inhibition areas 101 are regions on both sides of the antenna portion 62b of the BLE module 62 and regions that overlap the antenna portion 62b in the thickness direction of the BLE board 6 in all layers of the BLE board 6.

As shown in Fig. 10, the BLE board 6 has a substantially rectangular shape including a first side edge portion 201 and a second side edge portion 202, which form two sides facing each other in the widthwise direction, and a third side edge portion 203 and a fourth side edge portion 204, which form two sides facing each other in the longitudinal direction.

The first side edge portion 201 has a substantially linear shape. In the second side edge portion 202, a projecting portion 202a is formed. The third side edge portion 203 is formed into a substantially linear shape. Notch portions 204a and 204b are formed in the fourth side edge portion 204. The third side edge portion 203 is formed into a substantially linear shape.

The third side edge portion 203 is arranged close to the chassis 4. A part of the fourth side edge portion 204 is arranged close to a side edge portion of the USB board 8.

In the BLE board 6, the electronic components are mounted on the first surface 6A, and the third side edge portion 203 and the second surface 6B are fixed to the chassis 4. In the BLE board 6, the second surface 6B is close to the MCU board 7 and the USB board 8, and the first surface 6A is located on the reverse side of the second surface 6B at a position far apart from the MCU board 7 and the USB board 8.

On the first surface 6A of the BLE board 6, active components, passive components, and auxiliary components are mounted in addition to the BLE module 62.

An active component is an electronic component that has an input and an output and has a predetermined relationship between the input and the output by applying a voltage. The active component is an electronic component that can be a noise source. The active components are, for example, the LED 61, the case attachment/detachment detection circuit (Hall IC) 63, the Schmitt trigger circuit 64, the overvoltage protection elements (Zener diodes or varistors) 163a to 163d, and the like.

A passive component is an electronic component that does not function by itself but functions in combination with an active component. The passive components are, for example, the crystal oscillator 161, the capacitors 162a to 162h, the resistors 164a to 164c, and the like.

An auxiliary component is an electronic component that sets an electric circuit in an energized state or in a nonenergized state. The auxiliary component is, for example, the tactile switch 15.

On the first surface 6A of the BLE board 6, active components such as the LED 61, the case attachment/detachment detection circuit (Hall IC) 63, the Schmitt trigger circuit 64, and the overvoltage protection elements (Zener diodes or varistors) 163a to 163d, and auxiliary components such as the tactile switch 15 are mounted. Also, on the first surface 6A of the BLE board 6, passive components such as the crystal oscillator 161, the capacitors 162a to 162h, and the resistors 164a to 164c are mounted.

On the first surface 6A of the BLE board 6, a non-mounting region 150 on which no electronic components are mounted is provided between the BLE module 62 and the electronic components such as the LED 61 and the IC chips such as the case attachment/detachment detection circuit (Hall IC) 63 and the Schmitt trigger circuit 64.

The non-mounting region 150 is provided near the center between the first side edge portion 201 and the second side edge portion 202 on the first surface 6A of the BLE board 6 and between a part of the notch portion 204b of the fourth side edge portion 204 and the third side edge portion 203. The non-mounting region 150 occupies a rectangular portion including a first boundary portion 151 substantially parallel to the first side edge portion 201 of the BLE board 6, a second boundary portion 152 substantially parallel to the second side edge portion 202 of the BLE board 6, a fourth boundary portion 154 substantially parallel to the fourth side edge portion 204 of the BLE board 6, and a third boundary portion 153 substantially parallel to the third side edge portion 203 of the BLE board 6. In the rectangular shape, the length of each of the first boundary portion 151 and the second boundary portion 152 is shorter than the length of each of the fourth boundary portion 154 and the third boundary portion 153. It should be noted that the non-mounting region 150 in Fig. 10 is shown while being distinguished from the remaining portions of the first surface 6A of the BLE board 6 in order to facilitate understanding. The non-mounting region 150 may be a part of the first surface 6A of the BLE board 6, and the first boundary portion 151 to the fourth boundary portion 154 may be virtual boundaries.

In a planar view, the non-mounting region 150 includes a rectangular portion having an area equal to or larger than a larger one of the area of the BLE module 62 and the area of the case attachment/detachment detection circuit (Hall IC) 63 and the Schmitt trigger circuit 64. A part of the third boundary portion 153 of the non-mounting region 150 substantially matches a part of the third side edge portion 203 of the BLE board 6.

The BLE board 6 includes a first region 6A1 which is a region between the non-mounting region 150 and the first side edge portion 201 of the BLE board 6 and on which the BLE module 62 is mounted, and a second region 6A2 which is a region between the non-mounting region 150 and the second side edge portion 202 of the BLE board 6 and in which the IC chips such as the case attachment/detachment detection circuit (Hall IC) 63 and the Schmitt trigger circuit 64 are included. The number (M) of active components (the overvoltage protection elements 163a and 163b) included in the first region 6A1 is configured to be smaller than the number (N) of active components (the LED 61 and the overvoltage protection elements 163c and 163d) included in the second region 6A2 (M < N).

In the present embodiment, the active components included in the first region 6A1 are only the overvoltage protection elements 163a and 163b. That is, the number (M) of active components included in the first region 6A1 is 2. Also, the number (N) of active components included in the second region 6A2 is 20. Note that the number of active components included in the first region 6A2 may be zero, that is, no active components may be mounted.

On the first region 6A1 of the BLE board 6, the antenna portion 62b of the BLE module 62 is arranged at a position closest to the first side edge portion 201, and next to the antenna portion 62b, the integrated circuit portion 62a is arranged at a position farther from the first side edge portion 201 than the antenna portion 62b.

The integrated circuit portion 62a of the BLE module 62 includes a first side surface portion a1 adjacent to the antenna portion 62b, a second side surface portion a2 located at a position facing the first side surface portion a1 and located at a position farther from the antenna portion 62b than the first side surface portion a1, a third side surface portion a3 located at a position close to the third side edge portion 203 of the BLE board 6, and a fourth side surface portion a4 located at a position facing the third side surface portion a3 and located at a position closer to the fourth side edge portion 204 of the BLE board 6 than the third side surface portion a3.

Between the fourth side surface portion a4 of the integrated circuit portion 62a of the BLE module 62 and the fourth side edge portion 204 of the BLE board 6, four capacitors 162a to 162d and one crystal oscillator 161 are arrayed along the direction of the fourth side surface portion a4 of the integrated circuit portion 62a sequentially from the first side edge portion 201 of the BLE board 6. Also, between the second side surface portion a2 of the integrated circuit portion 62a of the BLE module 62 and the first boundary portion 151 of the non-mounting region 150, two capacitors 162e and 162f and two overvoltage protection elements 163a and 163b are arrayed along the direction of the third side surface portion a3 of the integrated circuit portion 62a sequentially from a side close to the first boundary portion 51 of the non-mounting region 150. The two capacitors 162e and 162f and the two overvoltage protection elements 163a and 163b are arranged apart in the direction of the first side edge portion 201 of the BLE board 6. In addition, the tactile switch 15 is arranged close to the first boundary portion 151 of the non-mounting region 150 and the third side edge portion 203 of the BLE board 6.

On the second region 6A2 of the BLE board 6, eight LEDs 61 are arrayed at a predetermined interval along the third side edge portion 203 of the BLE board 6 from the second boundary portion 152 of the non-mounting region 150 toward the second side edge portion 202 of the BLE board 6.

Also, between the fourth boundary portion 154 of the non-mounting region 150 and the fourth side edge portion 204 of the BLE board 6, three overvoltage protection elements 163c and one capacitor 162g are mounted along the fourth boundary portion 154 of the non-mounting region 150 and the fourth side edge portion 204 of the BLE board 6.

In addition, between the second boundary portion 152 of the non-mounting region 150 and the second side edge portion 202 of the BLE board 6, and between the fourth side edge portion 204 of the BLE board 6 and the eight LEDs 61, one capacitor 162g, three resistors 164a, nine overvoltage protection elements 163d, three resistors 164b, the Schmitt trigger circuit 64, the case attachment/detachment detection circuit (Hall IC) 63, two capacitors 162h, and three resistors 164c are mounted from the second boundary portion 152 of the non-mounting region 150 toward the second side edge portion 202 of the BLE board 6.

As for the nine overvoltage protection elements 163d, five overvoltage protection elements and four overvoltage protection elements are arranged in parallel along the fourth side edge portion 204 of the BLE board 6 from a side close to the fourth side edge portion 204 of the BLE board 6. As for the case attachment/detachment detection circuit (Hall IC) 63, the Schmitt trigger circuit 64, and the two capacitors 162h, the case attachment/detachment detection circuit (Hall IC) 63 and the Schmitt trigger circuit 64 are arranged along the fourth side edge portion 204 of the BLE board 6 from a side close to the fourth side edge portion 204 of the BLE board 6, and the case attachment/detachment detection circuit (Hall IC) 63, the Schmitt trigger circuit, and the two capacitors 162h are arranged in parallel along the fourth side edge portion 204 of the BLE board 6.

A configuration and effect for maintaining the communication state of the BLE module 62 according to the present embodiment in a satisfactory state will be described below.

As shown in Fig. 10, in the BLE module 62, the antenna portion 62b is closest to the first side edge portion 201 of the BLE board 6, and next to the antenna portion 62b, the integrated circuit portion 62a is arranged at a position farther from the first side edge portion 201 than the antenna portion 62b. The BLE module 62 is arranged such that the integrated circuit portion 62a and the antenna portion 62b are arranged in this order toward the first side edge portion 201. In other words, the integrated circuit portion 62a and the antenna portion 62b are arranged in this order with respect to the first side edge portion 201 of the BLE board 6 closest to the BLE module 62. That is, of the side edge portions of the BLE board 6, the first side edge portion 201 closest to the BLE module is located at a position closer to the antenna portion 62b than the integrated circuit portion 62a of the BLE module 62.

To avoid the influence on the communication state by the BLE module 62, as described above, it is preferable not to provide copper foil (conductive line) patterns around, immediately above, and immediately under the antenna portion 62b of the BLE module 62. In other words, if the antenna portion 62b of the BLE module 62 is mounted at or near the center of the BLE board 6, there is a great restriction on the shape of the BLE board 6 and mounting of other electronic components. However, if the antenna portion 62b of the BLE module 62 is mounted close to a side edge portion of the BLE board 6, such a restriction can be eliminated.

According to the present embodiment, when deciding the shapes of the circuit boards or mounting the electronic components other than the BLE module 62, a great degree of freedom can be ensured. It is therefore possible to reduce the cost and size of the aerosol generation device.

Also, a configuration in which, of the side edge portions of the BLE board 6, the first side edge portion 201 closest to the BLE module is located at a position closer to the antenna portion 62b than the other electronic component can be considered as a configuration in which the distance between the first side edge portion 201 of the BLE board 6 and the BLE module 62 is shorter than the distances between the first side edge portion 201 of the BLE board 6 and other electronic components. Also, the antenna portion 62b of the BLE module 62 may overlap the first side edge portion 201 of the BLE board 6. According to this configuration, when connecting copper foil (conductive line) patterns to the electronic components, complex wiring patterns that make detour around portions on the periphery of and immediately under the antenna portion 62b of the BLE module 62 are unnecessary. This makes it possible to ensure a great degree of freedom when deciding the shapes of the circuit boards or mounting the electronic components other than the BLE module 62 and reduce the cost and size of the aerosol generation device.

In addition, the antenna portion 62b of the BLE module 62 may project outward from the first side edge portion 201 of the BLE board 6 only by a predetermined small amount (for example, less than 1 mm). That is, a part of the antenna portion 62b may be exposed from the first side edge portion 201 of the BLE module 62 to the outside of the BLE board 6. According to this configuration, the area of the circuit board can effectively be used. It is therefore possible to ensure a great degree of freedom when deciding the shapes of the circuit boards or mounting the electronic components other than the BLE module 62, for example, mounting many electronic components on the circuit board, and reduce the cost and size of the aerosol generation device.

In the BLE board 6, the second surface 6B on the reverse side of the first surface 6A on which the BLE module 62 is mounted is fixed by the chassis 4. In a direction perpendicular to the first surface 6A of the BLE board 6, the chassis 4, the BLE board 6, and the antenna portion 62b are arranged in this order. According to this configuration, the space under the antenna portion 62b where the existence of a metal such as a copper foil (conductive line) pattern is not preferable is occupied by the chassis 4 having insulating properties and rigidity. Hence, even if an unexpected happening such as a fall occurs, entry of a metal into the region of the antenna portion 62b can be suppressed. It is therefore possible to implement a configuration in which interruption of communication by the BLE module 62 hardly occurs.

Also, the chassis 4 fixes the third side edge portion 203 of the BLE board 6, and the antenna portion 62b and the chassis 4 are adjacent in a direction parallel to the first surface 6A of the BLE board 6. Thus, the space on a side of the antenna portion 62b where the existence of a metal such as a copper foil (conductive line) pattern is not preferable is occupied by the chassis 4 having insulating properties and rigidity. Hence, even if an unexpected happening such as a fall occurs, entry of a metal into the region of the antenna portion 62b can be suppressed. It is therefore possible to implement a configuration in which interruption of communication by the BLE module 62 hardly occurs.

Furthermore, in the BLE board 6, the notch portions 204a and 204b are provided in the fourth side edge portion 204 that is not fixed to the chassis 4. The antenna portion 62b of the BLE module 62 includes, in a direction parallel to the first surface 6A of the BLE board 6, a third side surface portion b3 to which the chassis 4 is adjacent, and a fourth side surface portion b4 to which the chassis 4 is not adjacent. The fourth side surface portion b4 is closer to the notch portion 204a than the third side surface portion b3. According to this configuration, not all sides of the antenna portion 62b of the BLE module 62 need be occupied by the chassis 4. For a side that is not close to the chassis 4, the existence of a metal is not preferable. Hence, when the notch portion 204a is provided on the BLE board 6, the amounts of materials used to produce the chassis 4 and the circuit board decrease, and the cost of the device can be reduced.

Also, as shown in Fig. 14, other circuit boards are not arranged in a direction substantially perpendicular to the first surface 6A of the antenna portion 62b of the BLE module 62. According to this configuration, since no circuit boards are provided in the space above the antenna portion 62b where the existence of a metal such as a copper foil (conductive line) pattern is not preferable, it is possible to implement a configuration in which interruption of communication by the BLE module 62 hardly occurs.

The inner case 2 is arranged close to the antenna portion 62b in a direction substantially perpendicular to the first surface 6A of the antenna portion 62b of the BLE module 62. According to this configuration, the space above the antenna portion 62b where the existence of a metal such as a copper foil (conductive line) pattern is not preferable can be occupied by an insulating cover. Hence, even if an unexpected happening such as a fall occurs, entry of a metal into the region of the antenna portion 62b can be suppressed. It is therefore possible to implement a configuration in which interruption of communication by the BLE module 62 hardly occurs.

Also, the outer case 3 is arranged above the inner case 2 in a direction substantially perpendicular to the first surface 6A of the BLE board 6, and the outer case 3 covers the inner case 2. According to this configuration, since the region of the antenna portion 62b of the BLE module 62 is doubly shield by the inner case 2 and the outer case 3, the space above the antenna portion 62b where the existence of a metal such as a copper foil (conductive line) pattern is not preferable is occupied by the inner case 2 and the outer case 3. In addition, since external noise hardly reaches the region of the antenna portion 62b due to the existence of the two covers, it is possible to implement a configuration in which interruption of communication by the BLE module 62 hardly occurs.

Also, the magnets 11b provided on the outer case 3 and the magnets 11a that are provided on the chassis 4 and magnetically couple with the magnets 11b are arranged apart from the BLE module 62 by a predetermined distance. This makes it possible to easily exchange the outer case 3 in accordance with the tastes of the user and make it difficult for magnetic fields generated by the magnets 11a and 11b to affect communication by the BLE module 62. It is therefore possible to implement a configuration in which interruption of communication by the BLE module 62 hardly occurs while improving the merchantability of the device.

Note that in the present embodiment, the passive components 161 and 162a to 162f are preferentially arranged around the integrated circuit portion 62a of the BLE module 62 on the BLE board 6. These are arranged such that the distances from the BLE module 62 to the passive components 161 and 162a to 162f are shorter than the distances from the BLE module 62 to the active components 163a and 163b. More specifically, the electronic components are arranged such that, the distances between the BLE module 62 and, of the plurality of passive components, the closest passive components 161 and 162a to 162f closest to the BLE module 62 are shorter than the distances between the BLE module 62 and, of the plurality of active components, the closest active components 163a and 163b closest to the BLE module 62. According to this configuration, since the passive components are arranged closer to the BLE module 62 than the active components each of which may be a noise source, the BLE module 62 is hardly affected by noise generated in the active components. Hence, satisfactory communication by the BLE module 62 is possible.

The closest active components 163a and 163b are not elements that always function but include electronic components (Zener diodes or varistors) that function in an abnormal state, and therefore, do not steadily generate noise. When only such weak noise sources are arranged close to the BLE module 62, a great degree of freedom can be ensured when mounting the electronic components, as compared to a case where the components are not arranged. It is therefore possible to reduce the cost and size of the aerosol generation device.

The periphery of the BLE module 62 is surrounded by the plurality of passive components 161 and 162a to 162f. The plurality of passive components 161 and 162a to 162f include the passive components 161 and 162a to 162d mounted between the fourth side surface portion a4 of the integrated circuit portion 62a of the BLE module 62 and the fourth side edge portion 204 of the BLE board 6, and the passive components 162e and 162d mounted at positions facing the second side surface portion a2 of the integrated circuit portion 62a of the BLE module 62. According to this configuration, since the plurality of passive components 162a to 162f can be used as a physical barrier against noise to the BLE module 62, the communication state of the BLE module 62 can be held in a satisfactory state.

Also, in the first region 6A1 of the BLE board 6, of the plurality of passive components 161 and 162a to 162f, a specific passive component whose volume is not minimum (the capacitor 162f whose capacity is not minimum) is arranged between the BLE module 62 and the closest active components 163a and 163b. The closest active components 163a and 163b are mounted at positions facing the second side surface portion a2 of the integrated circuit portion 62a of the BLE module 62, and the specific passive component 162f is mounted closer to the second side surface portion a2 of the integrated circuit portion 62a of the BLE module 62 than the closest active components 163a and 163b, and has a volume (capacity) larger than the passive component 162a having the minimum volume (capacity) in the plurality of passive components 161 and 162a to 162f. According to this configuration, since the passive component 162f having a relatively large volume (capacity) can be used as a physical barrier against noise to the BLE module 62, it is possible to implement a configuration in which interruption of communication by the BLE module 62 hardly occurs.

In addition, the third side surface portion a3 of the integrated circuit portion 62a of the BLE module 62 is located at a position close to the third side edge portion 203 of the BLE board 6, and no electronic components are mounted between the third side edge portion 203 of the BLE board 6 and the third side surface portion a3 of the BLE module 62. In a direction parallel to the first surface 6A of the BLE board 6, the third side edge portion 203 of the BLE board 6 and the third side surface portion a3 of the BLE module 62 are adjacent to the chassis 4 as a positional relationship. According to this configuration, the space on one side portion of the antenna portion 62b where the existence of a metal such as a copper foil (conductive line) pattern is not preferable is occupied by the chassis 4 having insulating properties and rigidity. Hence, even if an unexpected happening such as a fall occurs, entry of a metal into the region of the antenna portion 62b can be suppressed. It is therefore possible to implement a configuration in which interruption of communication by the BLE module 62 hardly occurs.

The distance between the specific passive component 162f and the BLE module 62 is shorter than the distance between the specific passive component 162f and each of IC chips such as the case attachment/detachment detection circuit (Hall IC) 63 and the Schmitt trigger circuit 64 other than the BLE module 62. According to this configuration, since the specific passive component 162f can be used as a physical barrier against noise to the BLE module 62, the communication state of the BLE module 62 can be held in a satisfactory state.

Additionally, on the BLE board 6, the non-mounting region 150 where no electronic components are mounted is provided between the specific passive component 162f and the IC chips such as the case attachment/detachment detection circuit (Hall IC) 63 and the Schmitt trigger circuit 64 other than the BLE module 62. According to this configuration, since the IC chips 63 and 64 other than the BLE module 62 can be arranged sufficiently apart from the BLE module 62, it is possible to reduce the influence of noise derived from the other IC chips 63 and 64 on the BLE module 62 and maintain the communication state of the BLE module 62 in a satisfactory state.

Also, the distances between the closest active components 163a and 163b and the BLE module 62 are shorter than the distance between the closest active components 163a and 163b and the other IC chips 63 and 64 other than the BLE module 62. According to this configuration, the other IC chips 63 and 64 other than the BLE module 62, each of which may be a noise source as compared to the active components, can be arranged sufficiently apart from the BLE module 62. It is therefore possible to reduce the influence of noise derived from the other IC chips 63 and 64 on the BLE module 62 and maintain the communication state of the BLE module 62 in a satisfactory state.

In addition, as shown in Figs. 7 to 9C, the MCU 71, the first transformation circuit (switching regulator) 76a, and the second transformation circuit (switching regulator) 82a, each of which may be a noise source, are mounted on the MCU board 7 and the USB board 8 separated from the BLE board 6. Furthermore, the BLE module 62 is mounted at a position sufficiently apart from the MCU 71, the first transformation circuit 76a, and the second transformation circuit 82a. Also, the BLE board 6 is arranged while being offset with respect to the MCU board 7 and the USB board 8 such that the first side edge portion 201 of the BLE board 6 on which the BLE module 62 is mounted is located near the center of the MCU board 7 and the USB board 8 in the longitudinal direction. According to this configuration, since the BLE module 62 can be arranged sufficiently apart from the MCU 71, the first transformation circuit 76a, and the second transformation circuit 82a, each of which may be a noise source, the communication state of the BLE module 62 can be held in a satisfactory state.

Also, the MCU 71 is mounted on the MCU board 7, the second transformation circuit 82a is mounted on the USB board 8, and the BLE board 6 is located at a position sufficient apart from the MCU board 7 and the USB board 8. Since the MCU 71 and the second transformation circuit 82a, which may be noise sources to each other, are arranged at separate positions, it is possible to reduce the influence of one on the other, maintain the communication state of the BLE module 62 in a satisfactory state, and implement a stable operation of the aerosol generation device.

As shown in Figs. 11A and 11B, in the MCU board 7, the first surface 7A on which the MCU 71 is mounted is located at a position farther from the BLE board 6 than the second surface 7B on which the MCU 71 is not mounted. In other words, in the MCU board, the second surface 7B on which the MCU 71 is not mounted is located at a position closer to the BLE board 6 than the first surface 7A on which the MCU 71 is mounted. According to this configuration, since the MCU 71 that may be a noise source can be arranged as apart as possible from the BLE module 62, the communication state of the BLE module 62 can be held in a satisfactory state. Also, in the present embodiment, it can be interpreted that the second transformation circuit is formed by the DC/DC converter 82a and the reactor (power inductor) 82b. In this case, in the USB board 8, the second surface 8B on which, of the DC/DC converter 82a and the reactor 82b, which form the second transformation circuit, the reactor 82b is not mounted is located at a position closer to the BLE board 6 than the first surface 8A on which the reactor 82b is mounted. In other words, in the USB board 8, the first surface 8A on which the reactor 82b is mounted is located at a position farther from (a position that is not closest to) the BLE board 6 than the second surface 8B on which the reactor 82b is not mounted. During switching of the DC/DC converter 82a, a magnetic field is generated in and around the reactor 82b, and this magnetic field may exert an influence on the BLE module 62. Hence, when the reactor 82b of the second transformation circuit 82a is located sufficiently apart from the BLE module 62, the communication state of the BLE module 62 can be held in a satisfactory state.

Of the DC/DC converter 82a and the reactor 82b, which form the second transformation circuit, the DC/DC converter 82a is mounted on the second surface 8B of the USB board 8, and the reactor 82b is mounted on the first surface 8A of the USB board 8. When the DC/DC converter 82a and the reactor 82b, which generate heat during switching, are mounted on different surfaces of the USB board 8, heat can be prevented from being locally focused. Since the BLE module 62 is hardly affected by the heat, the communication state of the BLE module 62 can be held in a satisfactory state, and the durability of the device can be improved.

The distance between the BLE board 6 and the MCU board 7 is larger than the distance between the BLE board 6 and the USB board 8. According to this configuration, since, of the MCU 71 and the second transformation circuit 82a, the MCU 71 that may be a noise source at higher possibility is apart from the BLE module 62, the communication state of the BLE module 62 can be held in a satisfactory state.

Also, in the MCU board 7, the first surface 7A on which the MCU 71 is mounted is located at a position farthest from the BLE board 6. In other words, in the MCU board 7, the second surface 7B on which the MCU 71 is not mounted is located at a position closer to the BLE board 6 than the first surface 7A on which the MCU 71 is mounted. According to this configuration, when the MCU 71 that may be a noise source is arranged as apart as possible from the BLE module 62, the communication state of the BLE module 62 can be held in a satisfactory state.

Note that the invention is not limited to the foregoing embodiments, and various variations/changes are possible within the spirit of the invention.

This application claims priority from Japanese Patent Application No. 2021-079749 filed May 10, 2021, which is hereby incorporated by reference herein.

### REFERENCE SIGNS LIST

1...power source unit for aerosol generation device
2...inner case (first panel)
3...outer case (second panel)
4...chassis
5...heating unit
6...first circuit board (BLE board)
6A...first surface of first circuit board 6
6A1...first region of first surface 6A of first circuit board 6
6A2...second region of first surface 6A of first circuit board 6
6B...second surface of first circuit board 6
7...second circuit board (MCU board)
7A...first surface of second circuit board 7
7B...second surface of second circuit board 7
8...third circuit board (USB board)
8A...first surface of third circuit board 8
8B...second surface of third circuit board 8
10... battery
11a, 11b...magnet
25...heater
61...LED
62...BLE module
62a...integrated circuit portion of BLE module 62
62b...antenna portion of BLE module 62
a1...first side surface portion of integrated circuit portion 62a of BLE module 62
a2...second side surface portion of integrated circuit portion 62a of BLE module 62
a3...third side surface portion of integrated circuit portion 62a of BLE module 62
a4...fourth side surface portion of integrated circuit portion 62a of BLE module 62
b1...first side surface portion of antenna portion 62b of BLE module 62
b2...second side surface portion of antenna portion 62b of BLE module 62
b3...third side surface portion of antenna portion 62b of BLE module 62
b4...fourth side surface portion of antenna portion 62b of BLE module 62
63...case attachment/detachment detection circuit (Hall IC)
64...Schmitt trigger circuit (inverter)
71...MCU (controller)
76a...first transformation circuit (DC/DC converter IC)
76b...reactor (power inductor)
82a...second transformation circuit (DC/DC converter IC)
82b...reactor (power inductor)
150...non-mounting region
151...first boundary portion of non-mounting region 150
152...second boundary portion of non-mounting region 150
153...third boundary portion of non-mounting region 150
154...fourth boundary portion of non-mounting region 150
161...crystal oscillator (passive component)
162a - 162h...capacitor (passive component)
163a - 163d...overvoltage protection element (Zener diode or varistor, active component)
164a - 164c...resistor (passive component)
201...first side edge portion of BLE board 6
202...second side edge portion of BLE board 6
203...third side edge portion of BLE board 6
204...fourth side edge portion of BLE board 6
204a, 204b...notch portion

## Claims

1. A power source unit for an aerosol generation device, **characterized by** comprising:
a communication module including an integrated circuit portion and an antenna portion;
a power source configured to supply power for driving a heater configured to heat an aerosol source;
a controller configured to control the supply of the power from the power source to the heater; and
a circuit board on which the communication module and an electronic component are mounted,
wherein of a plurality of side edge portions of the circuit board, a first side edge portion closest to the communication module is located at a position closer to the antenna portion than the integrated circuit portion.

2. The power source unit for the aerosol generation device according to claim 1, **characterized in that** a distance between the first side edge portion and the communication module is shorter than a distance between the first side edge portion and the electronic component.

3. The power source unit for the aerosol generation device according to claim 1 or 2, **characterized in that** the antenna portion overlaps the first side edge portion.

4. The power source unit for the aerosol generation device according to claim 3, **characterized in that** a part of the antenna portion is exposed from the first side edge portion to outside the circuit board.

5. The power source unit for the aerosol generation device according to any one of claims 1 to 4, **characterized by** further comprising an insulating chassis configured to hold the circuit board,
wherein in a direction perpendicular to a mounting surface of the circuit board, the chassis, the circuit board, and the antenna portion are arranged in this order.

6. The power source unit for the aerosol generation device according to claim 5, **characterized in that** in a direction parallel to the mounting surface of the circuit board, the antenna portion and the chassis are adjacent.

7. The power source unit for the aerosol generation device according to claim 6, **characterized in that** the antenna portion includes, in the direction parallel to the mounting surface of the circuit board, a first side surface portion adjacent to the chassis, and a second side surface portion located at a position facing the first side surface portion, and
the circuit board includes a notch portion formed in a side edge portion located at a position closer to the second side surface portion than the first side surface portion.

8. The power source unit for the aerosol generation device according to any one of claims 1 to 7, **characterized in that** a region where no circuit board is arranged is provided above the antenna portion in the direction perpendicular to the mounting surface of the circuit board.

9. The power source unit for the aerosol generation device according to any one of claims 1 to 7, **characterized in that** an insulating first panel is arranged close to the antenna portion above the antenna portion in the direction perpendicular to the mounting surface of the circuit board.

10. The power source unit for the aerosol generation device according to claim 9, **characterized in that** a second panel that is an exterior member of the power source unit is arranged above the first panel in the direction perpendicular to the mounting surface of the circuit board.

11. The power source unit for the aerosol generation device according to claim 10, **characterized in that** to the first panel, a first magnet is exposed at a position apart from the antenna portion by a predetermined distance,
the second panel includes a second magnet magnetically coupled with the first magnet, and
the power source unit comprises an insulating chassis configured to hold the circuit board and the first magnet such that the first magnet is apart from the antenna portion by the predetermined distance.
